(19) **Europäisches Patentamt**

**European Patent Office**

**Office européen des brevets**

(11) **EP 1 260 998 A1**

(12) **EUROPEAN PATENT APPLICATION**
published in accordance with Art. 158(3) EPC

(43) Date of publication:
**27.11.2002 Bulletin 2002/48**

(51) Int Cl.$^7$: **H01G 4/20**, H01B 3/00

(21) Application number: **01996873.4**

(22) Date of filing: **16.11.2001**

(86) International application number:
**PCT/JP01/10055**

(87) International publication number:
**WO 02/041343 (23.05.2002 Gazette 2002/21)**

(84) Designated Contracting States:
**AT BE CH CY DE DK ES FI FR GB GR IE IT LI LU MC NL PT SE TR**

(30) Priority: **16.11.2000 JP 2000349784**

(71) Applicant: **TDK Corporation**
**Chuo-ku, Tokyo 103-8272 (JP)**

(72) Inventors:
• **TAKAYA, Minoru**
**Tokyo 103-8272 (JP)**

• **ENDO, Toshikazu**
**Tokyo 103-8272 (JP)**

(74) Representative:
**Strych, Werner Maximilian Josef, Dr.**
**Hansmann & Vogeser,**
**Patent- und Rechtsanwälte,**
**Albert-Rosshaupter-Strasse 65**
**81369 München (DE)**

(54) **ELECTRONIC COMPONENT-USE SUBSTRATE AND ELECTRONIC COMPONENT**

(57)    An object of the invention is to provide a substrate for an electronic part and an electronic part which have higher dielectric constant compared to conventional materials, which do not suffer from reduced strength, and which enjoy the advantages of small size, excellent performance and improved overall electrical characteristics; a substrate for an electronic part and an electronic part wherein the material used for the production exhibits reduced lot-to-lot variation in the electric properties, and in particular, in the dielectric constant, and wherein wearing of the mold in the production of the material has been suppressed; and a substrate for an electronic part and an electronic part which have a high withstand voltage. In order to attain such object, the substrate for an electronic part and the electronic part are constituted to comprise a composite dielectric material wherein at least a dielectric material having a circular, oblate circular or oval projection shape is dispersed in a resin.

FIG. 72A

FIG. 72B

FIG. 72C

FIG. 72D

EP 1 260 998 A1

**Description**

TECHNICAL FIELD

This invention relates to electronic parts and multilayer circuits wherein a prepreg or a substrate is employed, and more particularly, to such electronic parts which have been produced by using a prepreg or a substrate having a high dielectric constant and which are suitable for operation in a high frequency region (of at least 100 MHz).

BACKGROUND ART

In the field of electronic equipment for communication, commercial and industrial applications, the current mounting technology seeks further miniaturization and higher density packaging. Concomitant with this trend, materials are required to have better heat resistance, dimensional stability, electrical characteristics and moldability.

Known electronic parts or multilayer substrates for high frequency operation include sintered ferrite and sintered ceramics which are laminated and molded into substrate form. Laminating such materials into multilayer substrates has been practiced in the art because of the advantage of potential miniaturization.

The use of sintered ferrite and sintered ceramics, however, gives rise to several problems. A number of steps are involved in firing and thick film printing. Sintered materials suffer from inherent defects including cracks and warp caused by firing. Cracks are also induced by the differential thermal expansion between sintered material and printed circuit board. It is thus increasingly required to replace the sintered materials by resinous materials.

With resinous materials as such, however, a satisfactory dielectric constant is arrived at with great difficulty, and little improvement in magnetic permeability is achievable. Then, electronic parts utilizing resinous materials as such fail to provide satisfactory characteristics and become large in size, rendering it difficult to reduce the size and thickness of electronic parts.

It is also known from JP-A 10-270255, JP-A 11-192620 and JP-A 8-69712 to mix resinous materials with ceramic powder into composite materials. These composite materials, however, were insufficient in both dielectric constant and magnetic permeability. There was also a problem that increase in the loading of the ceramic powder for the purpose of increasing the dielectric constant was associated with decrease in the strength of the product, and hence, with an increased susceptibility to breakage during the handling and processing.

In addition, the materials used in these publications are pulverized material, and as a consequence, use of such material invites an undesirable acceleration in the wearing of the mold or the like used in the kneading and molding of such material. These materials also suffered from insufficient stability in the dispersion and packing density due to the inconsistent particle shape and size, and it has been difficult to increase the dielectric constant and to stabilize dielectric constant and magnetic permeability. Use of the pulverized material also invited an undesirable decrease in the withstand voltage due to the particle shape.

Japanese Patent Publication 7-56846, Japanese Patent No. 2830071, Japanese Patent No. 2876088, and Japanese Patent No. 2893351 disclose attempts of dispersing spherical powder magnetic material in a resin. These publications, however, only disclose use of ferrite magnetic powder, and use of other materials or use of a magnetic powder in combination with other materials is not discussed.

DISCLOSURE OF THE INVENTION

An object of the invention is to provide a substrate for an electronic part and an electronic part which have higher dielectric constant compared to conventional materials, which do not suffer from reduced strength, and which enjoy the advantages of small size, excellent performance and improved overall electrical characteristics.

Another object is to provide a substrate for an electronic part and an electronic part wherein the material used for the production exhibits reduced lot-to-lot variation in the electric properties, and in particular, in the dielectric constant, and wherein wearing of the mold in the production of the material has been suppressed.

Further object is to provide a substrate for an electronic part and an electronic part which have a high withstand voltage.

Such objects are attained by the invention of the constitution as described below.

(1) A substrate for an electronic part comprising a composite dielectric material wherein said composite dielectric material has at least a dielectric material having a circular, oblate circular or oval projection shape dispersed in a resin.

(2) A substrate for an electronic part according to the above (1) wherein said dielectric material having a projected image of circle has a mean particle size of 1 to 50 μm and a sphericity of 0.9 to 1.0.

(3) A substrate for an electronic part according to the above (1) or (2) wherein said composite dielectric material further comprises a magnetic powder.

(4) A substrate for an electronic part according to any one of the above (1) to (3) wherein said composite dielectric material further comprises a pulverized material.

(5) A substrate for an electronic part according to any one of the above (1) to (4) wherein said composite dielectric material further comprises a glass cloth embedded in the material.

(6) A substrate for an electronic part according to any one of the above (1) to (5) comprising two or more different composite dielectric materials.

(7) A substrate for an electronic part according to any one of the above (1) to (6) comprising at least one composite dielectric material and one or more flame retardant.

(8) An electronic part comprising the substrate for an electronic part of any one of the above (1) to (7).

BRIEF DESCRIPTION OF THE INVENTION

FIG. 1 illustrates an inductor as one exemplary electronic part of the invention.

FIG. 2 illustrates an inductor as another exemplary electronic part of the invention.

FIG. 3 illustrates an inductor as a further exemplary electronic part of the invention.

FIG. 4 illustrates an inductor as a still further exemplary electronic part of the invention.

FIG. 5 illustrates an inductor as a yet further exemplary electronic part of the invention.

FIG. 6 illustrates an inductor as a yet further exemplary electronic part of the invention.

FIG. 7 illustrates an inductor as a yet further exemplary electronic part of the invention.

FIG. 8 illustrates an inductor as a yet further exemplary electronic part of the invention.

FIG. 9 illustrates an inductor as a yet further exemplary electronic part of the invention.

FIGS. 10A and 10B are equivalent circuit diagrams of the inductor which is an exemplary electronic part of the invention.

FIG. 11 illustrates a capacitor as one exemplary electronic part of the invention.

FIG. 12 illustrates a capacitor as another exemplary electronic part of the invention.

FIG. 13 illustrates a capacitor as a further exemplary electronic part of the invention.

FIGS. 14A and 14B are equivalent circuit diagrams of the capacitor which is an exemplary electronic part of the invention.

FIG. 15 illustrates a balun transformer as one exemplary electronic part of the invention.

FIG. 16 illustrates a balun transformer as another exemplary electronic part of the invention.

FIG. 17 illustrates a balun transformer as a further exemplary electronic part of the invention.

FIG. 18 is an equivalent circuit diagram of the balun transformer which is an exemplary electronic part of the invention.

FIG. 19 illustrates a multilayer filter as one exemplary electronic part of the invention.

FIG. 20 illustrates a multilayer filter as another exemplary electronic part of the invention.

FIG. 21 is an equivalent circuit diagram of the multilayer filter which is an exemplary electronic part of the invention.

FIG. 22 is a graph showing transmission characteristics of the multilayer filter which is an exemplary electronic part of the invention.

FIG. 23 illustrates a multilayer filter as one exemplary electronic part of the invention.

FIG. 24 illustrates a multilayer filter as another exemplary electronic part of the invention.

FIG. 25 is an equivalent circuit diagram of the multilayer filter which is an exemplary electronic part of the invention.

FIG. 26 is a graph showing transmission characteristics of the multilayer filter which is an exemplary electronic part of the invention.

FIG. 27 illustrates a block filter as one exemplary electronic part of the invention.

FIG. 28 illustrates a block filter as another exemplary electronic part of the invention.

FIG. 29 illustrates a block filter as a further exemplary electronic part of the invention.

FIG. 30 illustrates a block filter as a still further exemplary electronic part of the invention.

FIG. 31 is an equivalent circuit diagrams of the inductor which is an exemplary electronic part of the invention.

FIG. 32 illustrates a mold for the block filter which is an exemplary electronic part of the invention.

FIG. 33 illustrates a coupler as one exemplary electronic part of the invention.

FIG. 34 illustrates a coupler as another exemplary electronic part of the invention.

FIG. 35 illustrates a coupler as a further exemplary electronic part of the invention.

FIG. 36 illustrates the internal connections of the coupler which is an exemplary electronic part of the invention.

FIG. 37 is an equivalent circuit diagram of the coupler which is an exemplary electronic part of the invention.

FIG. 38 illustrates an antenna as one exemplary electronic part of the invention.

FIGS. 39A to 39C illustrate an antenna as another exemplary electronic part of the invention.

FIG. 40 illustrates an antenna as a further exemplary electronic part of the invention.

FIG. 41 illustrates an antenna as a still further exemplary electronic part of the invention.

FIG. 42 illustrates an antenna as a yet still further exemplary electronic part of the invention.

FIG. 43 illustrates a patch antenna as one exemplary electronic part of the invention.

FIG. 44 illustrates a patch antenna as another exemplary electronic part of the invention.

FIG. 45 illustrates a patch antenna as a further exemplary electronic part of the invention.

FIG. 46 illustrates a patch antenna as a still further exemplary electronic part of the invention.

FIG. 47 illustrates a patch antenna as a yet still further exemplary electronic part of the invention.

FIG. 48 illustrates a patch antenna as a yet still further exemplary electronic part of the invention.

FIG. 49 illustrates a patch antenna as a yet still further exemplary electronic part of the invention.

FIG. 50 illustrates a patch antenna as a yet still further exemplary electronic part of the invention.

FIG. 51 illustrates a VCO as one exemplary electronic part of the invention.

FIG. 52 illustrates a VCO as another exemplary electronic part of the invention.

FIG. 53 is an equivalent circuit diagram of the VCO which is an exemplary electronic part of the invention.

FIG. 54 illustrate a power amplifier as one exemplary electronic part of the invention.

FIG. 55 illustrate a power amplifier as another exemplary electronic part of the invention.

FIG. 56 is an equivalent circuit diagram of the power amplifier which is an exemplary electronic part of the invention.

FIG. 57 illustrates a superposed module as one exemplary electronic part of the invention.

FIG. 58 illustrates a superposed module as another exemplary electronic part of the invention.

FIG. 59 is an equivalent circuit diagram of the superposed module which is an exemplary electronic part of the invention.

FIG. 60 illustrates an RF unit as one exemplary electronic part of the invention.

FIG. 61 illustrates an RF unit as another exemplary electronic part of the invention.

FIG. 62 illustrates an RF unit as a further exemplary electronic part of the invention.

FIG. 63 illustrates an RF unit as a still further exemplary electronic part of the invention.

FIG. 64 illustrates a resonator as one exemplary electronic part of the invention.

FIG. 65 illustrates a resonator as another exemplary electronic part of the invention.

FIG. 66 illustrates a resonator as a further exemplary electronic part of the invention.

FIG. 67 illustrates a resonator as a still further exemplary electronic part of the invention.

FIG. 68 illustrates a resonator as a yet still further exemplary electronic part of the invention.

FIG. 69 illustrates a resonator as a yet still further exemplary electronic part of the invention.

FIG. 70 is an equivalent circuit diagram of the resonator which is an exemplary electronic part of the invention.

FIG. 71 is a block diagram showing a high-frequency portion of a portable equipment as one exemplary electronic part of the invention.

FIGS. 72A to 72D illustrate steps of a process for forming a copper foil-clad substrate which is used in the present invention.

FIGS. 73A to 73D illustrate steps of another process for forming a copper foil-clad substrate which is used in the present invention.

FIG. 74 illustrates steps of a further process for forming a copper foil-clad substrate.

FIG. 75 illustrates steps of a still further process for forming a copper foil-clad substrate.

FIG. 76 illustrates steps of a process for forming a multilayer substrate.

FIG. 77 illustrates steps of another process for forming a multilayer substrate.

## BEST MODE FOR CARRYING OUT THE INVENTION

The invention is now described in further detail.

The substrate for an electronic part and the electronic part of the present invention comprises a composite dielectric material wherein at least a dielectric material having a circular, oblate circular or oval projection shape is dispersed in a resin.

When the dielectric material dispersed in the resin has a circular, oblate circular or oval projection shape, the surface of the dielectric material particles becomes smooth, and as a consequence, increase in the packing density and dispersibility of the dielectric material is enabled. In addition, the dielectric material will be uniformly surrounded by the resin material and the hybrid material will exhibit improved pressure resistance and strength. The damage on the mold used in the molding is also reduced and the mold will enjoy a prolonged life.

Preferably, the dielectric material has a spherical shape with a circular projected image. The dielectric material may preferably have a mean particle size of 0.1 to 50 $\mu$m, and more preferably 0.5 to 20 $\mu$m, and a sphericity of 0.9 to 1.0, and more preferably 0.95 to 1.0.

When the dielectric material has a mean particle size of less than 0.1 μm, surface area of the particles will be increased, and viscosity and thixotrophy after the dispersion and stirring will be increased to render increase of the packing density and kneading with the resin difficult. On the other hand, when the mean particle size is in excess of 50 μm, uniform dispersion and mixing will be difficult and the mixture will be inconsistent with accelerated sedimentation, and production of a compact article by molding will be difficult.

When the sphericity is less than 0.9, the particles will be less likely to be uniformly dispersed in the production of a molded article such as compressed core, and this may result in the inconsistent dielectric properties detracting from the desired properties and causing lot-to-lot as well as piece-to-piece variations of the products. The sphericity may be determined by measuring a plurality of randomly selected samples and calculating the average value, and this average value should be within the above-described range.

In the present invention, "spherical shape" "having a projected image of circle" includes not only the sphere having a smooth surface but also a polyhedron which resembles a sphere. To be more specific, "spherical shape" also includes isotropically symmetric polyhedrons surrounded by stable crystal faces as represented by Wulff's model which has a sphericity near 1. The "sphericity" used herein may be represented by Wadell's working sphericity which is the ratio of the diameter of the circle which has an area equal to the area of the projected image of the particle to the diameter of the smallest circle circumscribing the projected image of the particle.

Use of a dielectric material having the sphericity of less than 0.9 is also acceptable in the present invention as long as the particle surface is smooth and the particles have a circular, oblate circular or oval projection shape. Use of the material having such smooth surface prevents wearing of the molds. Use of a material having a smooth surface with a sphericity of less than 0.9 is more advantageous compared to the use of a material having sharp edges (at an acute angle) with a sphericity higher than 0.9.

The dielectric material of the present invention may further comprise a pulverized material. Incorporation of the pulverized material enables increase in the packing density. In this case, dielectric properties and other electric properties may be improved by the increase in the packing density at a sacrifice of the effect of suppressing the wearing of the mold. Any desirable embodiment may be adopted depending on the performance required for the resulting product.

When the pulverized material is incorporated, the pulverized material may preferably have a particle size of 0.01 to 100 μm, and more preferably 0.01 to 50 μm, and a mean particle size of 1 to 50 μm. Use of a pulverized material having such particle size results in sufficient dispersion of the material and satisfactory realization of the advantages of the present invention. When the pulverized material has a particle size below such range, specific surface area will be excessively large, and increase in the packing density will be difficult. On the other hand, use of the material having a particle size beyond such range results in the accelerated sedimentation of the particles when the material is incorporated in a paste, and uniform dispersion will be difficult. In addition, surface smoothness will be difficult to attain when a thin substrate or prepreg is to be produced. The lower limit of the particle size is around about 0.01 μm since production of a material having an excessively small particle size is difficult and impractical.

The powder of the dielectric material used in the present invention is preferably a ceramic powder, and any ceramic powder may be used insofar as it has a greater dielectric constant and Q value in the high-frequency region than the resin serving as a dispersing medium. It is acceptable to use two or more types of ceramic powders.

Preferably, a ceramic powder having a dielectric constant of 10 to 20,000 and a dielectric dissipation factor of up to 0.05 is used.

Where it is desired to provide a relatively high dielectric constant, the following materials are preferably used.

Preferred materials include titanium-barium-neodymium base ceramics, titanium-barium-tin base ceramics, lead-calcium base ceramics, titanium dioxide base ceramics, barium titanate base ceramics, lead titanate base ceramics, strontium titanate base ceramics, calcium titanate ceramics, bismuth titanate base ceramics, magnesium titanate base ceramics, $CaWO_4$ base ceramics, $Ba(Mg,Nb)O_3$ base ceramics, $Ba(Mg,Ta)O_3$ base ceramics, $Ba(Co,Mg,Nb)O_3$ base ceramics, and $Ba(Co,Mg,Ta)O_3$ base ceramics. The titanium dioxide base ceramics include one consisting of titanium dioxide and those ceramics containing minor amounts of additives in addition to titanium dioxide, while they should maintain the crystalline structure of titanium dioxide. The same applies to the remaining ceramics. Of the titanium dioxide base ceramics, those having the rutile structure are preferred.

Where it is desired to provide a high Q without excessively increasing a dielectric constant, the following materials are preferably used.

Preferred materials include silica, alumina, zirconia, potassium titanate whiskers, calcium titanate whiskers, barium titanate whiskers, zinc oxide whiskers, chopped glass, glass beads, carbon fibers, and magnesium oxide (or talc).

These materials may be used alone or in admixture of two or more. Mixtures may have any desired mixing ratio of two or more components.

To be more specific, use of the materials as mentioned below is preferable when the material is not required to have a relatively high dielectric constant.

$Mg_2SiO_4$ [$\varepsilon$ = 7, Q = 20000], $Al_2O_3$ [$\varepsilon$ = 9.8, Q = 40000], $MgTiO_3$ [$\varepsilon$ = 17, Q = 22000], $ZnTiO_3$ [$\varepsilon$ = 26, Q = 800], $Zn_2TiO_4$ [$\varepsilon$ = 15, Q = 700], $TiO_2$ [$\varepsilon$ = 104, Q = 15000], $CaTiO_3$ [$\varepsilon$ = 170, Q = 1800], $SrTiO_3$ [$\varepsilon$ = 255, Q = 700], $SrZrO_3$ [$\varepsilon$ = 30, Q = 1200], $BaTi_2O_5$ [$\varepsilon$ = 42, Q = 5700], $BaTi_4O_9$ [$\varepsilon$ = 38, Q = 9000], $Ba_2Ti_9O_{20}$ [$\varepsilon$ = 39, Q = 9000], $Ba_2$(Ti,Sn)$_9O_{20}$ [$\varepsilon$ = 37, Q = 5000], $ZrTiO_4$ [$\varepsilon$ = 39, Q = 7000], (Zr,Sn)$TiO_4$ [$\varepsilon$ = 38, Q = 7000], $BaNd_2Ti_5O_{14}$ [$\varepsilon$ = 83, Q = 2100], $BaSm_2TiO_{14}$ [$\varepsilon$ = 74, Q = 2400], $Bi_2O_3$-$BaO$-$Nd_2O_3$-$TiO_2$ base [$\varepsilon$ = 88, Q = 2000], $PbO$-$BaO$-$Nd_2O_3$-$TiO_2$ base [$\varepsilon$ = 90, Q = 5200], ($Bi_2O_3$, PbO)-$BaO$-$Nd_2O_3$-$TiO_2$ base [$\varepsilon$ = 105, Q = 2500], $La_2Ti_2O_7$ [$\varepsilon$ = 44, Q = 4000], $Nd_2Ti_2O_7$ [$\varepsilon$ = 37, Q = 1100], (Li,Sm)$TiO_3$ [$\varepsilon$ = 81, Q = 2050], $Ba(Mg_{1/3}Ta_{2/3})O_3$ [$\varepsilon$ = 25, Q = 35000], $Ba(Zn_{1/3}Ta_{2/3})O_3$ [$\varepsilon$ = 30, Q = 14000], $Ba(Zn_{1/3}Nb_{2/3})O_3$ [$\varepsilon$ = 41, Q = 9200], $Sr(Zn_{1/3}Nb_{2/3})O_3$ [$\varepsilon$ = 40, Q = 4000], and the like.

More preferably, the material is the one containing the substance of the following composition as its main component.

$TiO_2$, $CaTiO_3$, $SrTiO_3$, $BaO$-$Nd_2O_3$-$TiO_2$ base, $Bi_2O_3$-$BaO$-$Nd_2O_3$-$TiO_2$ base, $BaTi_4O_9$, $Ba_2Ti_9O_{20}$, $Ba_2$(Ti,Sn)$_9O_{20}$ base, $MgO$-$TiO_2$ base, $ZnO$-$TiO_2$ base, $MgO$-$SiO_2$ base, $Al_2O_3$, and the like.

On the other hand, use of the materials as mentioned below is preferable when the material is required to have a relatively high dielectric constant.

$BaTiO_3$ [$\varepsilon$ = 1500], (Ba,Pb)$TiO_3$ base [$\varepsilon$ = 6000], $Ba(Ti,Zr)O_3$ base [$\varepsilon$ = 9000], and (Ba,Sr)$TiO_3$ base [$\varepsilon$ = 7000].

More preferably, the material is selected from powder dielectric materials based on the following compositions as its main component.

$BaTiO_3$ and $Ba(Ti,Zr)O_3$ base.

The ceramic powder may also be a single crystal or polycrystalline powder.

The content of ceramic powder is generally from 10% by volume to 65% by volume provided that the total of the resin and ceramic powder is 100% by volume. Preferably, the content of ceramic powder is 20 to 60% by volume.

A ceramic powder content of more than 65% by volume may fail to provide a consolidated layer and rather result in a substantial drop of Q as compared with ceramic powder-free compositions. With less than 10% by volume, ceramic powder may fail to exert the desired effect.

By properly selecting the respective components within the above range, the substrate for electronic parts and the electronic part of the present invention can have a greater dielectric constant than that of the resin alone, that is, have a dielectric constant as desired and a high Q.

The means used for dividing these ceramic powder into particles of spherical shape or the like may be a well-known techniques such the one using a spray dryer. To be more specific, the powder mixture to be processed may be dispersed and stirred in a dispersion medium to produce a slurry of predetermined concentration, and the slurry may be spray dried to produce spherical particles. The spherical particles may then be sintered.

The resin used in the substrate for electronic parts and the electronic part of the present invention is not critical. A proper choice may be made among resin materials having good moldability, processibility, adhesion during stacking, and electrical characteristics. Specifically, thermosetting resins and thermoplastic resins are preferred.

The thermosetting resins which can be used herein include epoxy resins, phenolic resins, unsaturated polyester resins, vinyl ester resins, polyimide resins, polyphenylene ether (or oxide) resins, bismaleimide triazine (or cyanate) resins, fumarate resins, polybutadiene resins, and polyvinyl benzyl ether resins. The thermoplastic resins which can be used herein include aromatic polyester resins, polyphenylene sulfide resins, polyethylene terephthalate resins, polybutylene terephthalate resins, polyethylene sulfide resins, polyether ether ketone resins, polytetrafluoroethylene resins, and graft resins. Among these, phenolic resins, epoxy resins, low dielectric constant epoxy resins, polybutadiene resins, BT resins, and polyvinyl benzyl ether resins are preferred as the base resin.

These resins may be used alone or in admixture of two or more. Mixtures may have any desired mixing ratio of two or more resin components.

The substrate for an electronic part and the electronic part of the present invention may comprise a stuck comprising two or more different composite dielectric materials. In addition, the composite dielectric material may comprise two or more different materials dispersed in the composite material. Such combination of two or more different composite dielectric materials or two or more different powder materials, and combination of two or more powder materials of the same type having different compositions, electric properties (such as dielectric constant), or magnetic characteristics with the resin facilitates adjustment of the dielectric constant or the magnetic permeability, enabling production of electronic parts having the optimal properties. To be more specific, adjustment of the dielectric constant and the magnetic permeability which are effective in the wavelength reduction to their optimal value enables reduction of the size and thickness of the device. In addition, combination of a material which exhibits favorable electric properties in the relatively low frequency region with a material which exhibits favorable electric properties in the relatively high frequency region facilitates realization of improved electric properties in a wide frequency region.

When the substrate for electronic parts and the electronic part are fabricated using the hybrid layers, bonding with copper foil with no use of adhesive, patterning, and lamination is enabled. Such patterning and lamination can be conducted through the same steps as conventional substrate manufacturing steps, contributing to a cost reduction and efficient manufacture. Electronic parts using the thus fabricated substrates have a high strength and improved high-frequency characteristics.

Increase in the dielectric constant has the effect of reducing the wavelength. To be more specific, the effective wavelength λ on the substrate is given by

$$\lambda = \lambda_0 /(\varepsilon \cdot \mu)^{1/2}$$

wherein $\lambda_0$ is the wavelength used, and ε and μ are the dielectric constant and the magnetic permeability of the electronic part or the substrate, respectively. Accordingly, when an electronic part or circuit at λ/4 is designed, size of the part requiring the length of λ/4 can be reduced by a length of the wavelength divided by the square root of the product of ε and μ by increasing the ε and the μ of the member constituting the circuit. Reduction in size of the electronic part or the substrate is thereby enabled at least by increasing the ε of the material used for the electronic part or the substrate.

In addition, combination of a material which exhibits favorable electric properties in the relatively low frequency region with a material which exhibits favorable electric properties in the relatively high frequency region facilitates realization of improved electric properties including HPF in a wide frequency region typically in the range of 1 to 2000 MHz, and in particular, in the range of 50 to 1000 MHz.

To be more specific, if the only object was the reduction of the wavelength, such object can be achieved by mixing a material having a high dielectric constant into the resin material. The material having a high dielectric constant, however, is not sufficient in high-frequency characteristics, and the high-frequency characteristics should be improved by other means. If the material having a high dielectric constant, for example, $BaTiO_3$, $BaZrO_3$, or the like is used with a magnetic material having favorable high-frequency characteristics, for example, iron carbonyl, the resulting product will also exhibit desired properties in high-frequency region.

The electronic parts requiring such reduction in the wavelength and high-frequency characteristics include multilayer filter, balun transformer, dielectric filter, coupler, antenna, VCO (voltage controlled oscillator), RF (radio frequency) unit, and resonator.

Use of two or more materials is also preferable because, when one electric property is improved by incorporating a material, other insufficient electric properties can be compensated by incorporating other materials.

The substrate for an electronic part and the electronic part of the present invention may further comprise one or more magnetic material in addition to the composite dielectric material comprising the dielectric material and the resin as described above.

The dielectric material used may be a ferrite. Examples of the ferrite include Mn-Mg-Zn, Ni-Zn, and Mn-Zn base systems, with the single crystal of such ferrite, Mn-Mg-Zn and Ni-Zn base systems being particularly preferred.

Alternatively, the dielectric material used may be a ferromagnetic metal. Exemplary ferromagnetic metals include iron carbonyl, iron-silicon base alloys, iron-aluminum-silicon base alloys (trade name: Sendust), iron-nickel base alloys (trade name: Permalloy), and amorphous alloys including iron and cobalt base alloys.

Means for dividing these materials into particles may be well-known techniques such as grinding and granulation.

The powder magnetic material may have a particle size and a shape similar to those of the dielectric material, and the powder magnetic material is preferably the one having a smooth surface as in the case of the dielectric material. Use of a pulverized material, however, is also acceptable, and merits similar to those described above will be attained by the use of such pulverized material.

It is acceptable to use two or more powder magnetic materials which differ in type or particle size distribution. Such different powder magnetic materials may be mixed in any desired ratio. The type, the particle size, and the mixing ratio of the powder magnetic materials may be determined depending on a particular application.

The powder magnetic material preferably has a magnetic permeability μ of 10 to 1,000,000. It is preferred that the powder magnetic material in bulk form has greater insulation because substrates formed therefrom are improved in insulation.

The resin and the powder magnetic material are preferably mixed in such a ratio that the resulting layer in its entirety has a magnetic permeability of 3 to 20. At the stage of a paste to be applied to glass cloth, the content of powder magnetic material is 10 to 65% by volume, especially 20 to 60% by volume, based on the total of the resin and the powder magnetic material. The content of the powder magnetic material within this range ensures that the resulting layer in its entirety has a magnetic permeability of 3 to 20, enabling to attain desired electric properties. Too large a powder magnetic material content may result in a reduced dielectric constant making it difficult to form a slurry for coating and hence, to form an electronic part, a substrate or prepreg. Too small a powder magnetic material content may fail to provide the desired magnetic permeability, detracting from magnetic characteristics.

The flame retardant used herein may be selected from a variety of flame retardants which are conventionally used for rendering substrates flame retardant. Exemplary flame retardants include halides such as halogenated phosphates and brominated epoxy resins, organic compounds such as phosphate amides, and inorganic substances such as antimony trioxide and aluminum hydride.

The reinforcing fibers used herein, typically in the form of glass cloth, may be selected from a variety of known reinforcements depending on a particular purpose and application. Commercially available reinforcements may be used without further treatment. Exemplary reinforcing fibers are E glass cloth ($\varepsilon = 7$, $\tan\delta = 0.003$ at 1 Gigahertz), D glass cloth ($\varepsilon = 4$, $\tan\delta = 0.0013$ at 1 Gigahertz) and H glass cloth ($\varepsilon = 11$, $\tan\delta = 0.003$ at 1 Gigahertz), from which a choice may be made depending on the desired electrical characteristics. Reinforcing fibers may be subject to coupling treatment in order to enhance interlayer adhesion. The glass cloth preferably has a thickness of up to 100 μm, more preferably 20 to 60 μm, and a weight of up to 120 g/m$^2$, especially 20 to 70 g/m$^2$.

Preferably the resin and glass cloth are mixed in a weight ratio of from 4/1 to 1/1. A mixing ratio within this range ensures to exert the desired effect. With a lower ratio or a smaller content of epoxy resin, the resulting composite material may lose adhesion to copper foil and form a less flat substrate. Inversely, with a higher ratio or a larger content of epoxy resin, the choice of glass cloth which can be used may become difficult and it may become difficult to ensure the strength of a thin-wall substrate.

The metal foil used herein as the conductor layer may be selected from metals having good electrical conductivity such as gold, silver, copper and aluminum. Of these, copper is especially preferred.

The metal foil may be formed by well-known methods such as electrolysis and rolling. Electrolytic foil is preferably used where it is desired to provide a foil peel strength. Rolled foil which is least affected by the skin effect due to surface irregularities is preferably used where high-frequency characteristics are important.

The metal foil preferably has a gage of about 8 to 70 μm, especially about 12 to 35 μm.

Prepreg sheets from which the substrate for an electronic part and the electronic part are fabricated are prepared in the present invention by mixing the dielectric material, optional magnetic material and optional flame retardant with the resin in a predetermined blend ratio, and milling the ingredients in a solvent into a paste in the form of a slurry, followed by coating and drying to B stage. The solvent used herein for adjusting the viscosity of the paste for ease of coating is preferably a volatile solvent, especially a polar neutral solvent. Milling may be effected by well-known techniques such as ball milling and agitation. A prepreg sheet can be fabricated by coating the paste onto a metal foil or impregnating glass cloth with the paste.

Drying of the prepreg sheet to B stage may be appropriately adjusted depending on the contents of powder dielectric material, optional powder magnetic powder, and optional flame retardant. After drying, the B stage prepreg sheet preferably has a thickness of about 50 to 300 μm and can be adjusted to an optimum thickness depending on the intended application and required characteristics (including pattern width, precision and DC resistance).

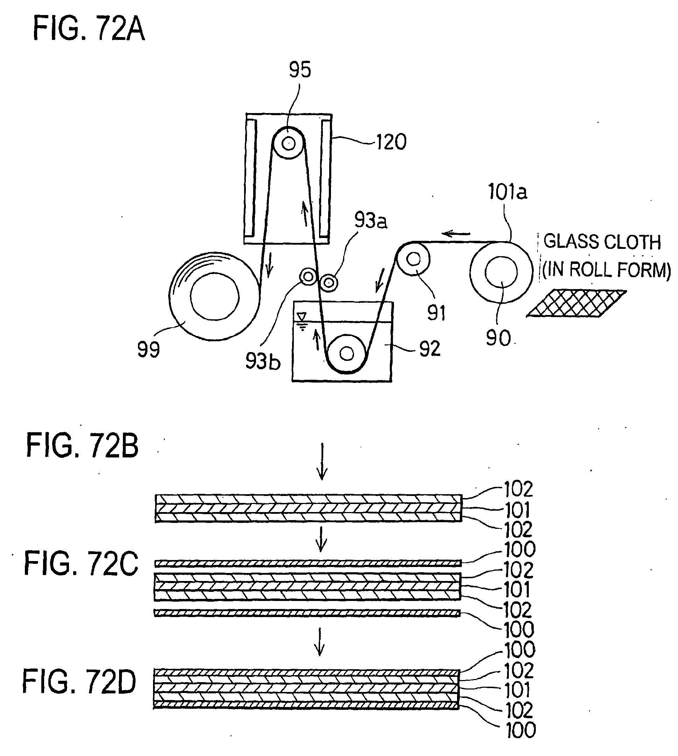

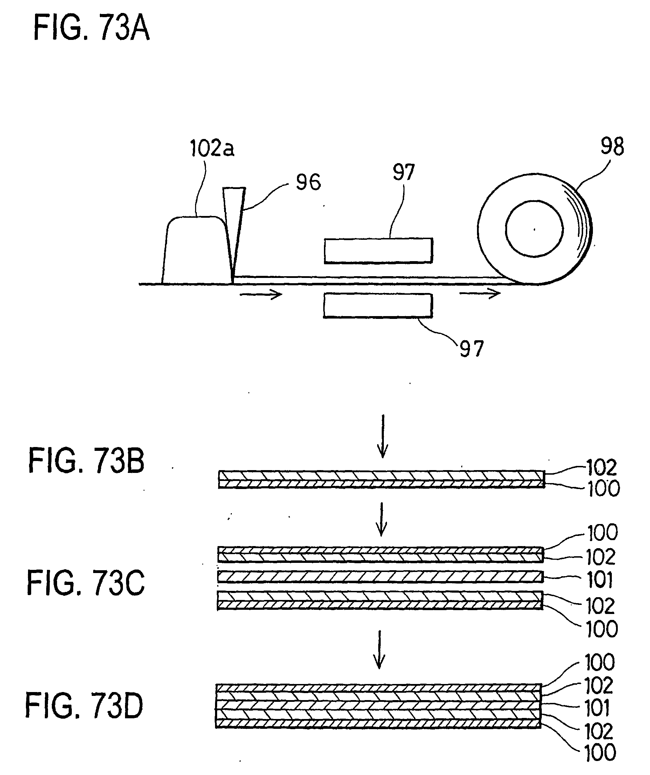

The prepreg sheet can be fabricated by the method shown in FIGS. 72A to 72D or 73A to 73D. The method of FIG. 72 is rather suitable for mass manufacture whereas the method of FIG. 73 is easy to control the film thickness and relatively easy to adjust the characteristics. In the method of FIG. 72, as shown in FIG. 72A, a glass cloth 101a wound in roll form is unraveled from the roll 90 and carried into a coating tank 92 via a guide roller 91. The coating tank 92 contains a slurry having the powder dielectric material and the resin, optional powder magnetic material and optional flame retardant dispersed in a solvent. As the glass cloth passes through the coating tank 92, it is immersed in the slurry so that it is coated with the slurry while interstices are filled therewith.

Past the coating tank 92, the glass cloth is carried into a drying furnace 120 via guide rollers 93a and 93b. In the drying furnace 120, the resin-impregnated glass cloth is dried at a predetermined temperature for a predetermined time whereby it is B-staged. After turning around a guide roller 95, the glass cloth is wound on a take-up roll 99.

The glass cloth is then cut into sections of a predetermined size. As shown in FIG. 72B, there is obtained a prepreg sheet having the glass cloth 101 sandwiched between the layers 102 of the resin containing the powder dielectric material and optional magnetic powder and optional flame retardant.

Then as shown in FIG. 72C, metal foils 100 such as copper foils are placed on opposite surface of the prepreg sheet. Laminating press at an elevated temperature and pressure yields a double side metal foil-clad substrate as shown in FIG. 72D. Laminating press may be effected in plural stages under different conditions. Where the metal foils are not attached, the sandwich structure of prepreg sheet may be lamination pressed without placing metal foils thereon.

Next, the method of FIG. 73 is described. As shown in FIG. 73A in FIG. 73, a slurry 102a having the resin, powder dielectric material, and optional powder magnetic material and optional flame retardant dispersed in a solvent is coated onto a metal foil such as a copper foil by means of a doctor blade 96 which can maintain a constant clearance.

The coated foil is then cut into sections of a predetermined size. As shown in FIG. 73B, there is obtained a prepreg sheet in which the layer 102 of the resin containing the powder dielectric material with optional powder magnetic material and optional flame retardant is disposed on one surface of the metal foil 100.

As shown in FIG. 73C, two such prepreg sheets 102 are placed on opposite surfaces of a glass cloth 101 such that the resin layers 102 face inside. Laminating press with heat and pressure yields a double side metal foil-clad substrate as shown in FIG. 73D. The heat and pressure conditions may be the same as above.

Besides the above-mentioned coating methods, the substrate or prepreg by which the electronic part is constructed may be prepared by another method, for example, by milling the ingredients and molding the solid mixture.

This method using the solid mixture is easy to provide a thickness and suitable for forming relatively thick substrates or prepregs.

Milling may be effected by well-known techniques using ball mills, agitators and kneaders. A solvent may be used during the milling, if necessary. The mixture may be pelletized or powdered, if necessary.

The prepreg sheet thus obtained generally has a thickness of about 0.05 to 5 mm. The thickness of the prepreg sheet may be determined as appropriate depending on the desired plate thickness and the contents of powder dielectric material and powder magnetic material.

As in the preceding methods, metal foils such as copper foils are placed on opposite surfaces of the resulting prepreg sheet, followed by laminating press. This yields a double side metal foil-clad substrate. Laminating press may be effected in plural stages under different conditions. Where the metal foils are not attached, the prepreg sheet may be lamination pressed without placing metal foils thereon.

The thus obtained substrate or organic composite material serving as a molding material has improved high-frequency characteristics of magnetic permeability and dielectric constant. It also has improved insulating characteristics or withstands well as an insulator. In the case of copper foil-clad substrates to be described later, the bond strength of the substrate to the copper foil is high enough. The substrate also has improved heat resistance, especially solder heat resistance.

A copper foil-clad substrate can be formed by placing copper foils over the prepreg sheet, followed by laminating press. The copper foils used herein typically have a thickness of about 12 to 35 $\mu$m.

The copper foil-clad substrates include double side patterned substrates and multilayer substrates.

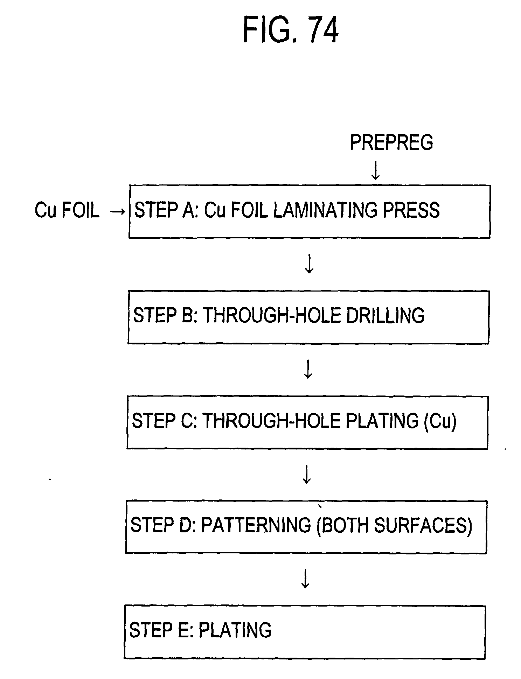

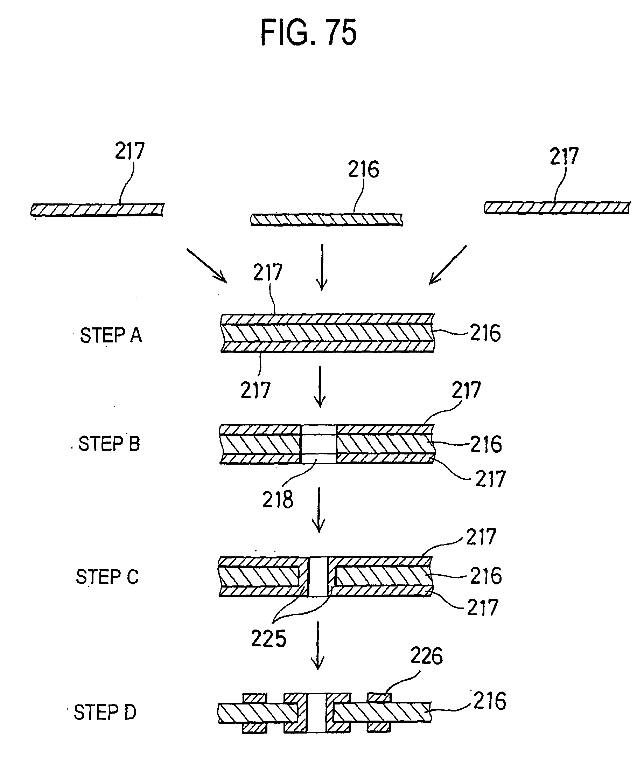

FIGS. 74 and 75 illustrate steps of an exemplary process of preparing a double side patterned substrate. As shown in FIGS. 74 and 75, a prepreg sheet 216 of a predetermined thickness is sandwiched between a pair of copper (Cu) foils 217 of a predetermined thickness, and the laminate was pressed at elevated temperature and pressure (step A). Next, through holes 218 are drilled in (step B). Copper (Cu) is then plated to the through hole 218 to form a plating film 225 (step C). Then, both the copper foils 217 are patterned to form conductor patterns 226 (step D). Thereafter, plating is effected for connection to external terminals as shown in FIG. 74 (step E). The last-mentioned plating may be Ni plating followed by Pd plating, Ni plating followed by Au plating (plating may be either electrolytic or electroless plating), or carried out using a solder leveler.

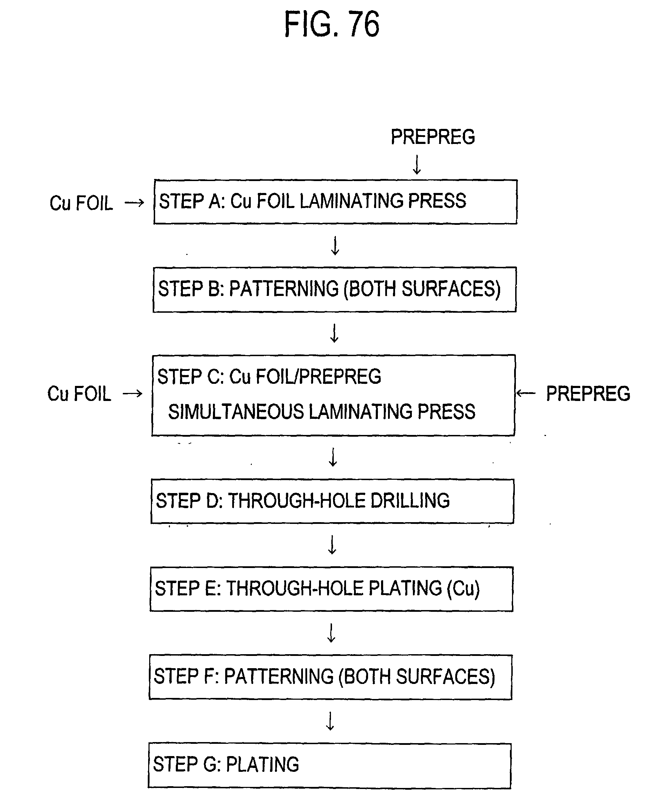

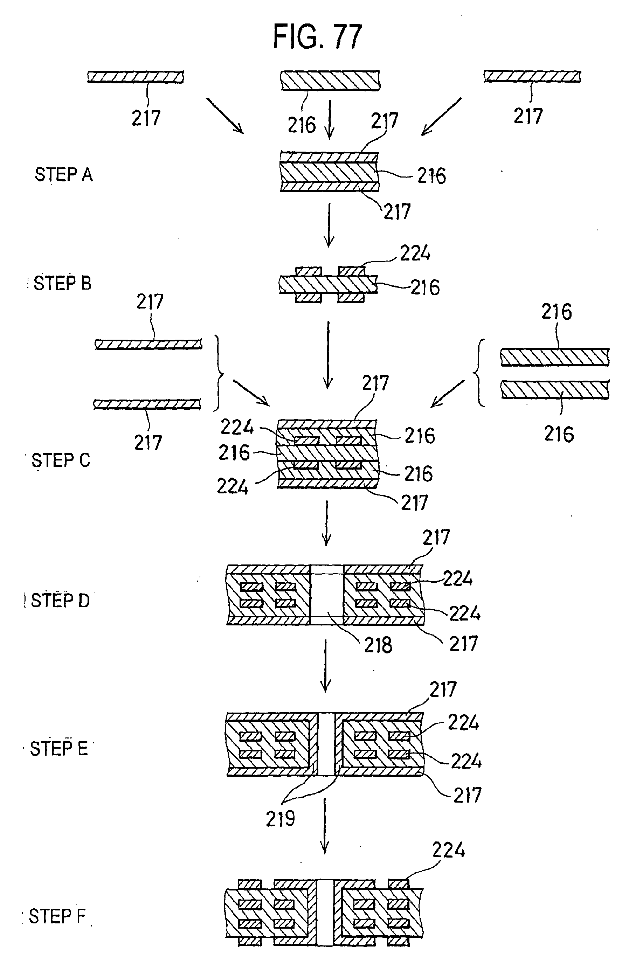

FIGS. 76 and 77 illustrate steps of an exemplary process of preparing a multilayer substrate in which four layers are stacked. As shown in FIGS. 76 and 77, a prepreg sheet 216 of a predetermined thickness is sandwiched between a pair of copper (Cu) foils 217 of a predetermined thickness, and the laminate was pressed at an elevated temperature and pressure (step a). Then, both the copper foils 217 are patterned to form conductor patterns 224 (step b). On each of opposite surfaces of the double side patterned substrate thus obtained, a prepreg sheet 216 of a predetermined thickness and a copper foil 217 are placed, followed by simultaneous lamination press (step c). Then, through holes 218 are drilled (step d). Copper (Cu) is plated to the through hole 218 to form a plating film 219 (step e). Then, both the outside copper foils 217 are patterned to form conductor patterns 224 (step F). Thereafter, plating is effected for connection to external terminals as shown in FIG. 76 (step g). The last-mentioned plating may be Ni plating followed by Pd plating, Ni plating followed by Au plating (plating may be either electrolytic or electroless plating), or carried out using a solder leveler.

The invention is not limited to the above-illustrated substrates, and a substrate of any desired structure can be formed. For example, using a substrate serving as a laminating press material, a copper foil-clad substrate and a prepreg, a multilayer structure can be formed while the prepreg serves as a bonding layer.

In the embodiment wherein a prepreg or a substrate serving as a laminating press material is bonded to a copper foil, a paste of hybrid material obtained by milling the powder dielectric material, powder magnetic material, metal powder coated with dielectric material, magnetic metal powder coated with insulator material, optional flame retardant and the resin in a high-boiling solvent such as butylcarbitol acetate may be applied onto a patterned substrate by a screen printing or similar technique. This procedure is effective for improving characteristics.

Electronic parts can be fabricated by combining the prepreg, copper foil-clad substrate and multilayer substrate with a device design pattern and other constituent materials.

The electronic parts of the invention find use as capacitors, coils (inductors), filters, etc. Alternatively, by combining these elements with each other or with wiring patterns, amplifier devices or functional devices, the electronic parts can form antennas, and high-frequency electronic parts such as superposed modules for use in high-frequency electronic circuits such as RF modules (RF amplifier stage), VCO (voltage controlled oscillators), and power amplifiers (power amplifier stage), as well as optical pickups.

EXAMPLES

Experimental examples and working examples of the invention are given below to further illustrate the invention.

Experiment 1

There were furnished resin materials as shown in Tables 1-1 and 1-2. The resin materials were mixed with powder dielectric materials and powder magnetic materials as shown in Tables 1-1 and 1-2 in a predetermined proportion to form composite materials, which were measured for dielectric constant $\varepsilon$. The results are shown in Tables 1-1 and 1-2. Decrease in the dielectric constant due to the incorporation of the magnetic material is also indicated with the comparative samples. It is to be noted that, in Table 1-1, the samples with the powder dielectric material content of 50% by volume are the conventional samples given for comparison purpose, and the samples with the powder dielectric material content of 60% by volume are the samples of the present invention. It is also to be noted that, in Table 1-1, the $(\varepsilon \times \mu)^{1/2}$ was calculated by assuming that $\mu = 1$ since no powder magnetic material had been incorporated.

Table 1-1

| Resin | Dielectric const. of the resin | Powder dielectric material | | Difference in Dielectric constant by the content | | Composite dielectric material $(\varepsilon \times \mu)^{1/2}$ |
|---|---|---|---|---|---|---|
| | | Type | Dielectric const. | 50 vol% | 60 vol% | |
| Phenol | 4.2 | BaTiO$_3$-BaZrO$_3$ | 9000 | 24.24 | 38.1 | 6.17252 |
| | | BaO-TiO$_2$-Nd$_2$O$_3$ | 95 | 16.90 | 23.6 | 4.85798 |
| Epoxy | 4 | BaTiO$_3$-BaZrO$_3$ | 9000 | 23.21 | 36.3 | 6.02495 |
| | | BaO-TiO$_2$-Nd$_2$O$_3$ | 95 | 16.43 | 23.0 | 4.79583 |
| Low-dielectric constant Epoxy | 3.5 | BaTiO$_3$-BaZrO$_3$ | 9000 | 20.62 | 32.6 | 5.70964 |
| | | BaO-TiO$_2$-Nd$_2$O$_3$ | 95 | 15.19 | 21.5 | 4.63681 |
| BT resin | 3 | BaTiO$_3$-BaZrO$_3$ | 9000 | 18.04 | 28.1 | 5.30094 |
| | | BaO-TiO$_2$-Nd$_2$O$_3$ | 95 | 13.84 | 19.5 | 4.41588 |
| Poly-butadiene | 2.5 | BaTiO$_3$-BaZrO$_3$ | 9000 | 15.44 | 24.0 | 4.89898 |
| | | BaO-TiO$_2$-Nd$_2$O$_3$ | 95 | 12.37 | 17.8 | 4.2190 |

In the table, the dielectric constant $\varepsilon$ of the sample containing 50 vol% of the powder dielectric material that of the comparative sample. $(\varepsilon \times \mu)^{1/2}$ was calculated by assuming that $\mu = 1$.

EP 1 260 998 A1

Table 1-2

| Resin | Dielectric const. of the resin | Powder dielectric material | | | Powder magnetic material | | | Composite dielectric material | | |
|---|---|---|---|---|---|---|---|---|---|---|
| | | Type | Dielectric const. | Content (vol%) | Type | Magnetic permeability | Content (vol%) | Dielectric const. | Magnetic permeability | $(\varepsilon \times \mu)^{1/2}$ |
| Phenol | 4.2 | $BaTiO_3-BaZrO_3$ | 9000 | 40 | Mn-Mg-Zn | 320 | 20 | 26.56 | 2.4 | 7.983984 |
| | | $BaO-TiO_2-Nd_2O_3$ | 95 | 40 | Mn-Mg-Zn | 320 | 20 | 18.65 | 2.4 | 6.690291 |
| Epoxy | 4 | $BaTiO_3-BaZrO_3$ | 9000 | 40 | Mn-Mg-Zn | 320 | 20 | 25.04 | 2.2 | 7.422129 |
| | | $BaO-TiO_2-Nd_2O_3$ | 95 | 40 | Mn-Mg-Zn | 320 | 20 | 17.87 | 2.2 | 6.270088 |
| Low-dielectric constant Epoxy | 3.5 | $BaTiO_3-BaZrO_3$ | 9000 | 40 | Mn-Mg-Zn | 320 | 20 | 24.53 | 2.3 | 7.511258 |
| | | $BaO-TiO_2-Nd_2O_3$ | 95 | 40 | Mn-Mg-Zn | 320 | 20 | 17.60 | 2.3 | 6.362389 |
| BT resin | 3 | $BaTiO_3-BaZrO_3$ | 9000 | 40 | Mn-Mg-Zn | 320 | 20 | 24.02 | 2.0 | 6.931089 |
| | | $BaO-TiO_2-Nd_2O_3$ | 95 | 40 | Mn-Mg-Zn | 320 | 20 | 17.33 | 2.0 | 5.887274 |
| Poly-butadiene | 2.5 | $BaTiO_3-BaZrO_3$ | 9000 | 40 | Mn-Mg-Zn | 320 | 20 | 23.00 | 2.1 | 6.94982 |
| | | $BaO-TiO_2-Nd_2O_3$ | 95 | 40 | Mn-Mg-Zn | 320 | 20 | 16.79 | 2.1 | 5.937929 |

As seen from Tables 1-1 and 1-2, the maximum content of the powder dielectric material and the powder magnetic material incorporated in the resin used increased from 50% by volume to 60% by volume compared to the conventional powder dielectric material. The dielectric constant has also increased. The results also reveal that $(\varepsilon \times \mu)^{1/2}$ somewhat increases even when the powder magnetic material is incorporated.

Example 1

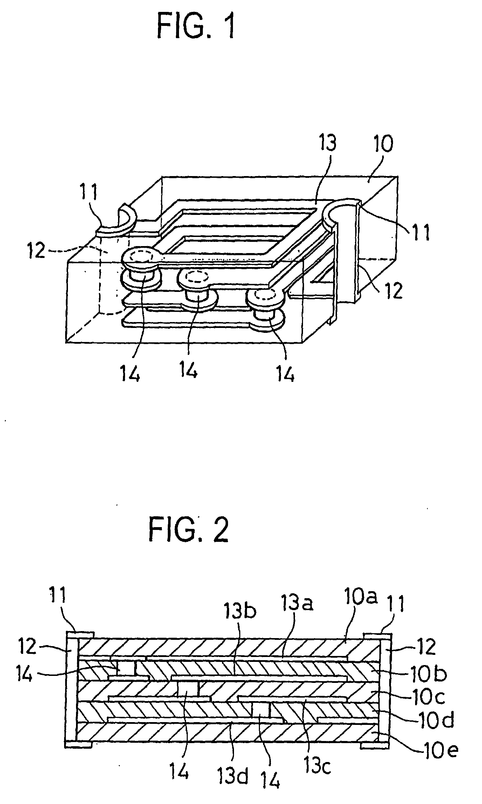

FIGS. 1 and 2 illustrate an inductor according to a first embodiment of the invention. FIG. 1 is a see-through perspective view and FIG. 2 is a cross-sectional view.

In FIGS. 1 and 2, the inductor 10 includes constituent layers (prepregs or substrates) 10a to 10e of resin materials of the invention, internal conductors (coil patterns) 13 formed on the constituent layers 10b to 10e, and via holes 14 for providing electrical connection to the internal conductors 13. Via holes 14 can be formed by drilling, laser machining, etching or the like. The ends of each coil formed are connected to through-vias 12 formed along end surfaces of the inductor 10 and land patterns 11 formed slightly above or below the through-vias 12. Through-via 12 has a half-cut structure by dicing or V-cutting. This is because when a plurality of devices are formed in a collective substrate which is eventually cut into discrete pieces along lines at the centers of through-vias 12.

At least one of the constituent layers 10a to 10e of the inductor 10 comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized form.

The composite dielectric material should preferably have a dielectric constant of 2.6 to 3.5 because the distributed capacitance must be minimized for the potential application as a high-frequency chip inductor. Separately, for an inductor constructing a resonance circuit, the distributed capacitance is sometimes positively utilized. In such application, the constituent layers should preferably have a dielectric constant of 5 to 40. In this way, it becomes possible to reduce the size of device and eliminate capacitive elements. Also, in these inductors, the material loss should be minimized. By setting the dielectric dissipation factor (tanδ) in the range of 0.0025 to 0.0075, an inductor having a minimized material loss and a high Q is obtainable. Further, where a noise removing application is under consideration, the impedance must be maximized at the frequency of noise to be removed. For such application, a magnetic permeability of 3 to 20 is appropriate, and use of the above-mentioned composite magnetic layers is preferred. This drastically improves the effect of removing high-frequency noise. The respective constituent layers may be identical or different as long as constituent layers of at least two different types are included as a whole (the same applies in the following examples), and an optimum combination thereof may be selected.

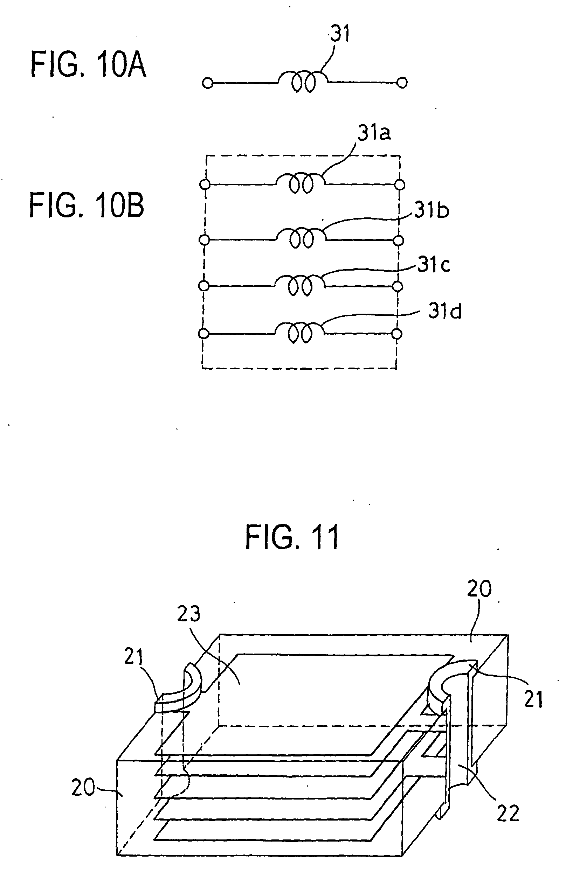

An equivalent circuit is shown in FIG. 10A. As seen from FIG. 10A, an electronic part (inductor) having a coil 31 is illustrated in the equivalent circuit.

Example 2

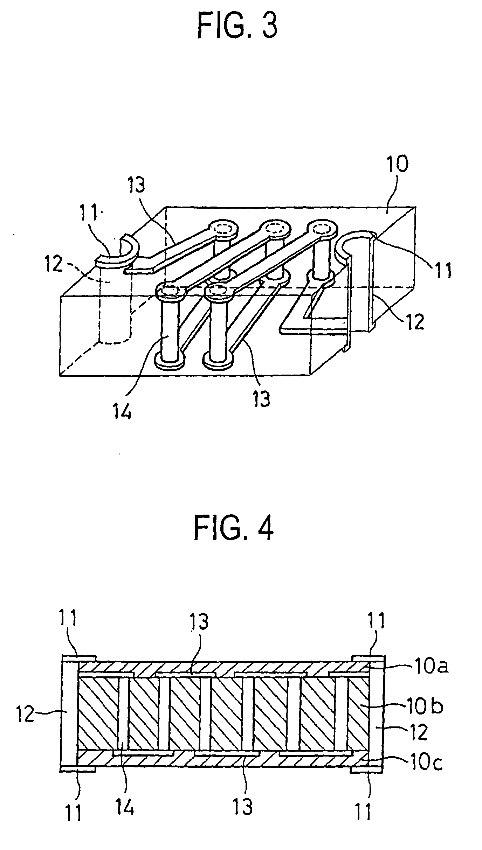

FIGS. 3 and 4 illustrate an inductor according to a second embodiment of the invention. FIG. 3 is a see-through perspective view and FIG. 4 is a cross-sectional view.

In this example, the coil pattern which is wound and stacked in a vertical direction in Example 1 is changed to a helical coil which is wound in a lateral direction. The remaining components are the same as in Example 1. The same components are designated by like numerals and their description is omitted.

Example 3

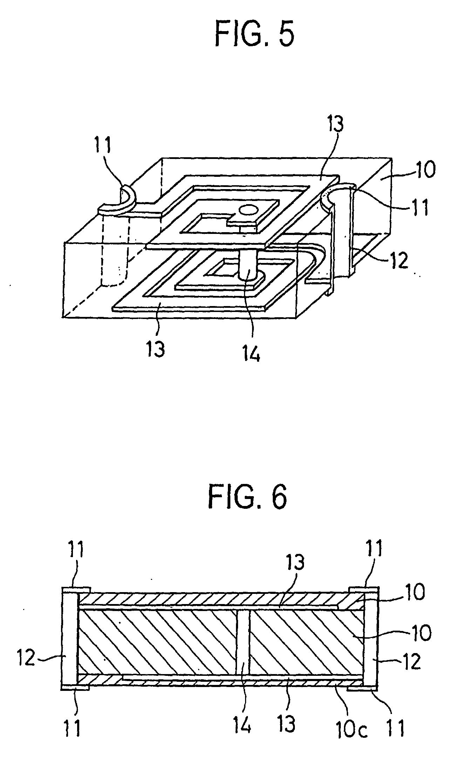

FIGS. 5 and 6 illustrate an inductor according to a third embodiment of the invention. FIG. 5 is a see-through perspective view and FIG. 6 is a cross-sectional view.

In this example, the coil pattern which is wound and stacked in a vertical direction in Example 1 is changed such that upper and lower spiral coils are connected. The remaining components are the same as in Example 1. The same components are designated by like numerals and their description is omitted.

Example 4

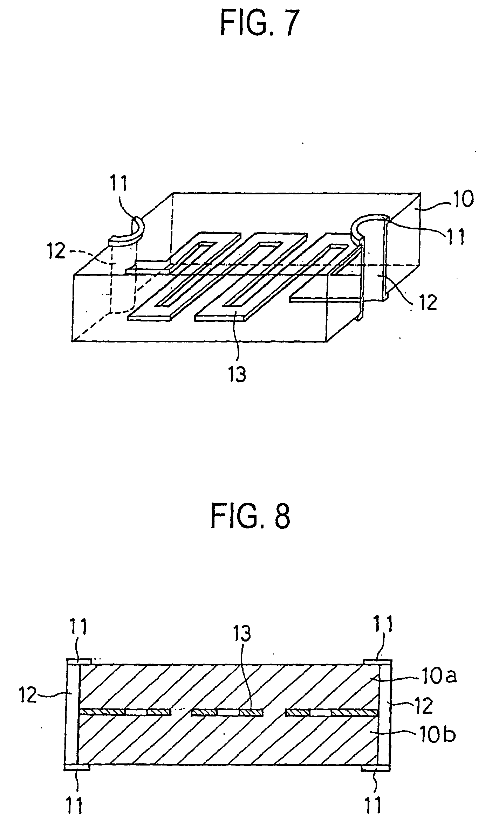

FIGS. 7 and 8 illustrate an inductor according to a fourth embodiment of the invention. FIG. 7 is a see-through perspective view and FIG. 8 is a cross-sectional view.

In this example, the coil pattern which is wound and stacked in a vertical direction in Example 1 is changed to an internal meander coil. The remaining components are the same as in Example 1. The same components are designated by like numerals and their description is omitted.

Example 5

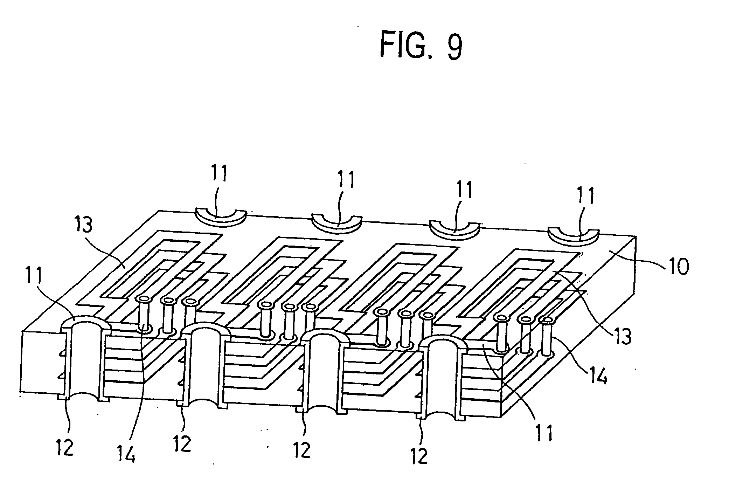

FIG. 9 is a see-through perspective view of an inductor according to a fifth embodiment of the invention.
In this example, the single coil in Example 1 is changed to an array of four juxtaposed coils. This array achieves a space saving. The remaining components are the same as in Example 1. The same components are designated by like numerals and their description is omitted. The equivalent circuit is shown in FIG. 10B. As shown in FIG. 10B, an electronic part (inductor) having four coils 31a to 31d is illustrated in the equivalent circuit.

Example 6

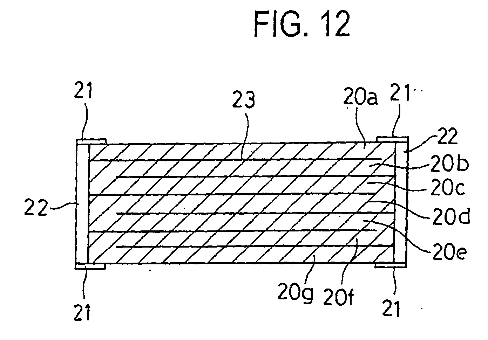

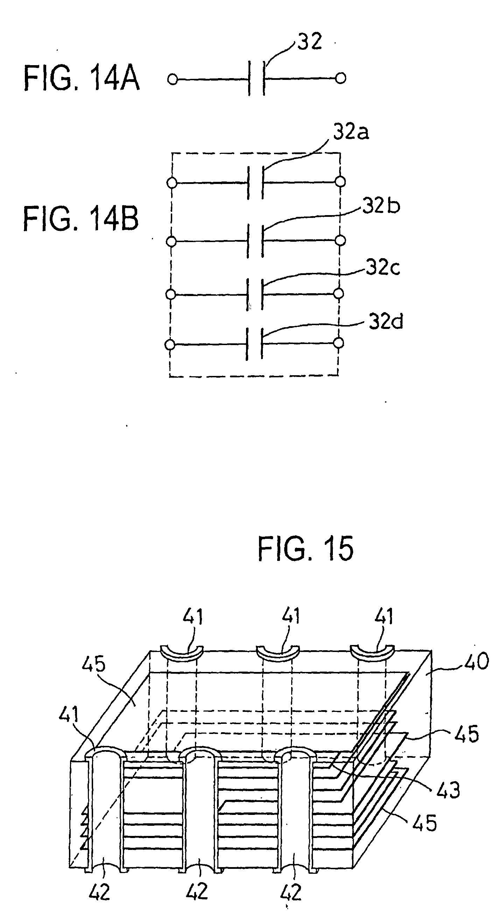

FIGS. 11 and 12 illustrate a capacitor according to a sixth embodiment of the invention. FIG. 11 is a see-through perspective view and FIG. 12 is a cross-sectional view.
In FIGS. 11 and 12, the capacitor 20 includes constituent layers (prepregs or substrates) 20a to 20g of resin materials of the invention, internal conductors (internal electrode patterns) 23 formed on the constituent layers 20b to 20g, through-vias 22 formed along end surfaces of the capacitor and alternately connected to the internal conductors 23, and land patterns 21 formed slightly above or below the through-vias 22.
At least one of the constituent layers 20a to 20g of the capacitor 20 comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.
The composite dielectric material should preferably have a dielectric constant of 2.6 to 40 and a dielectric dissipation factor of 0.0025 to 0.025 when the diversity and precision of capacitance are considered. This enables to provide a wider range of capacitance and afford even a low capacitance at a high precision. It is also required that the material loss be minimized. By setting the dielectric dissipation factor (tan$\delta$) in the range of 0.0025 to 0.025, a capacitor having a minimized material loss is obtainable. The respective constituent layers may be identical or different and an optimum combination thereof may be selected.
The equivalent circuit is shown in FIG. 14A. As shown in FIG. 14A, an electronic part (capacitor) having a capacitance 32 is illustrated in the equivalent circuit.

Example 7

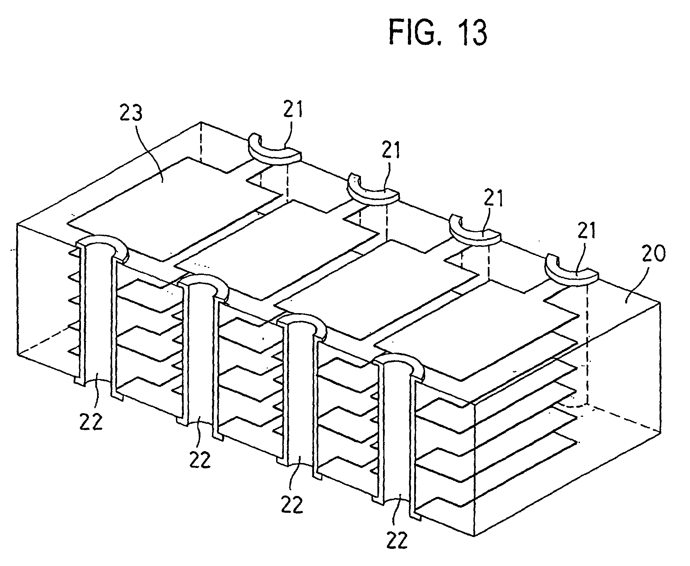

FIG. 13 is a see-through perspective view of a capacitor according to a seventh embodiment of the invention.
In this example, the single capacitor in Example 6 is changed to an array of four juxtaposed capacitors. When capacitors are formed in an array, it sometimes occurs to provide different capacitances at a high precision. To this end, the above-mentioned ranges of dielectric constant and dielectric dissipation factor are preferable. The remaining components are the same as in Example 6. The same components are designated by like numerals and their description is omitted. The equivalent circuit is shown in FIG. 14B. As shown in FIG. 14B, an electronic part (capacitor) having four capacitors 32a to 32d is illustrated in the equivalent circuit.

Example 8

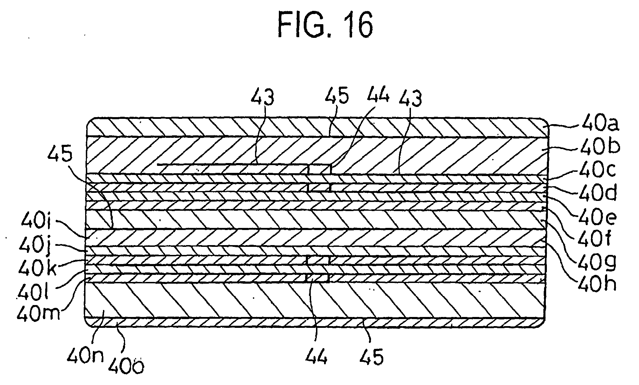

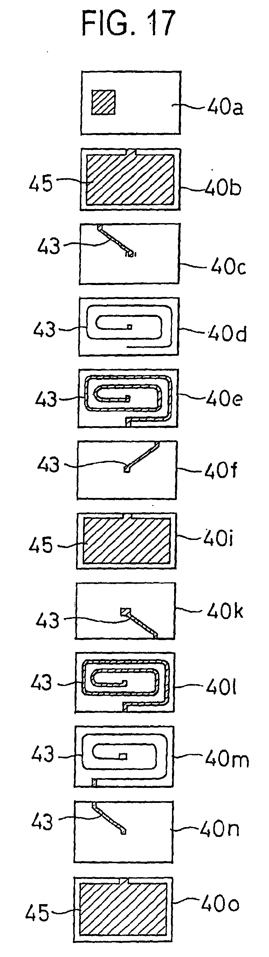

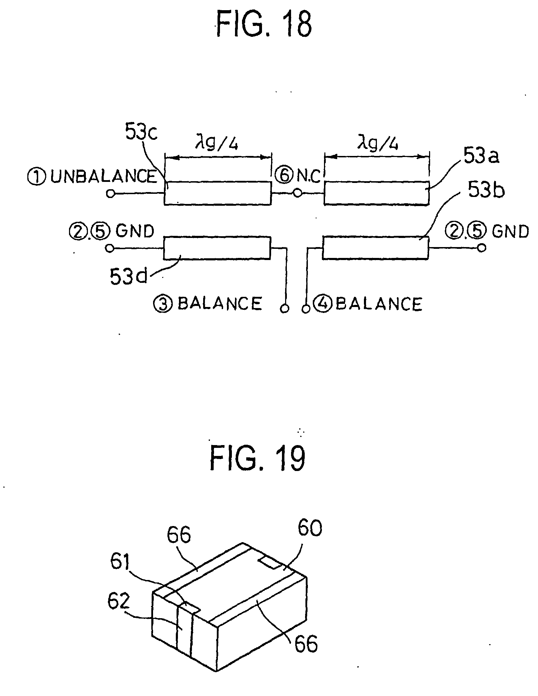

FIGS. 15 to 18 illustrate a balun transformer according to an eighth embodiment of the invention. FIG. 15 is a see-through perspective view, FIG. 16 is a cross-sectional view, FIG. 17 is an exploded plan view of respective constituent layers, and FIG. 18 is an equivalent circuit diagram.
In FIGS. 15 to 17, the balun transformer 40 includes a stack of constituent layers 40a to 40o, internal GND conductors 45 disposed above, below and intermediate the stack, and internal conductors 43 formed between the internal GND conductors 45. The internal conductors 43 are spiral conductor sections 43 having a length of $\lambda$g/4 which are connected by via holes 44 so as to construct coupling lines 53a to 53d as shown in the equivalent circuit of FIG. 18.
At least one of the constituent layers 40a to 40o of the balun transformer 40 comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.
The composite dielectric material should preferably have a dielectric constant of 2.6 to 40 and a dielectric dissipation factor (tan$\delta$) of 0.0025 to 0.025. In some applications, a magnetic permeability of 3 to 20 is appropriate.

The respective constituent layers may be identical or different and an optimum combination thereof may be selected.

Example 9

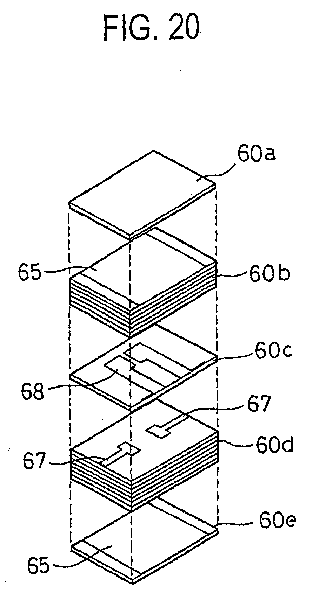

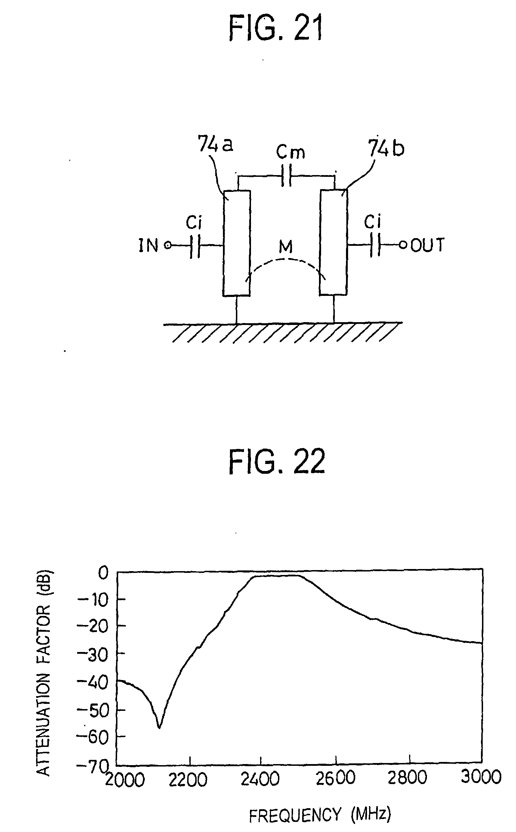

FIGS. 19 to 22 illustrate a multilayer filter according to a ninth embodiment of the invention. FIG. 19 is a perspective view, FIG. 20 is an exploded perspective view, FIG. 21 is an equivalent circuit diagram, and FIG. 22 is a transmission diagram. The multilayer filter is constructed as having two poles.

In FIGS. 19 to 21, the multilayer filter 60 includes a stack of constituent layers 60a to 60e, a pair of strip lines 68 and a pair of capacitor conductors 67 both disposed approximately at the center of the stack. The capacitor conductors 67 are formed on a lower constituent layer group 60d, and the strip lines 68 are formed on a constituent layer 60c thereon. GND conductors 65 are formed on upper and lower end surfaces of the constituent layers 60a to 60e so that the strip lines 68 and capacitor conductors 67 are interleaved therebetween. The strip lines 68, capacitor conductors 67 and GND conductors 65 are connected to end electrodes (external terminals) 62 formed on end sides and land patterns 61 formed slightly above or below the end electrodes 62. GND patterns 66 which are formed on opposite sides and slightly above or below therefrom are connected to GND conductors 65.

The strip lines 68 are strip lines 74a, 74b having a length of $\lambda g/4$ or shorter as shown in the equivalent circuit of FIG. 21. The capacitor conductors 67 constitute input and output coupling capacitances Ci. The strip lines 74a and 74b are coupled by a coupling capacitance Cm and a coupling coefficient M. Such an equivalent circuit indicates the implementation of a multilayer filter having transmission characteristics of the two pole type as shown in FIG. 22.

At least one of the constituent layers 60a to 60e of the multilayer filter 60 comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

The composite dielectric material exhibits desired transmission characteristics in a frequency band of several hundreds of megahertz to several gigahertz when the constituent layers 60a to 60e have a dielectric constant of 2.6 to 40. It is desired to minimize the material loss of the strip line resonator, and hence, setting a dielectric dissipation factor (tan$\delta$) in the range of 0.0025 to 0.0075 is preferable. The respective constituent layers may be identical or different and an optimum combination thereof may be selected.

Example 10

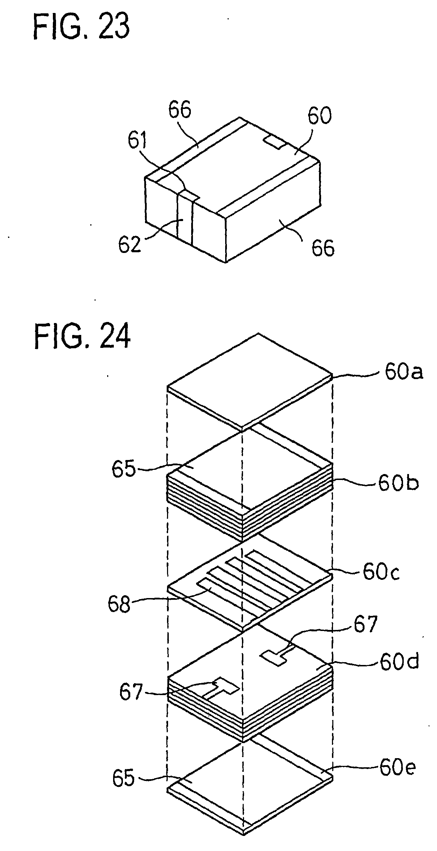

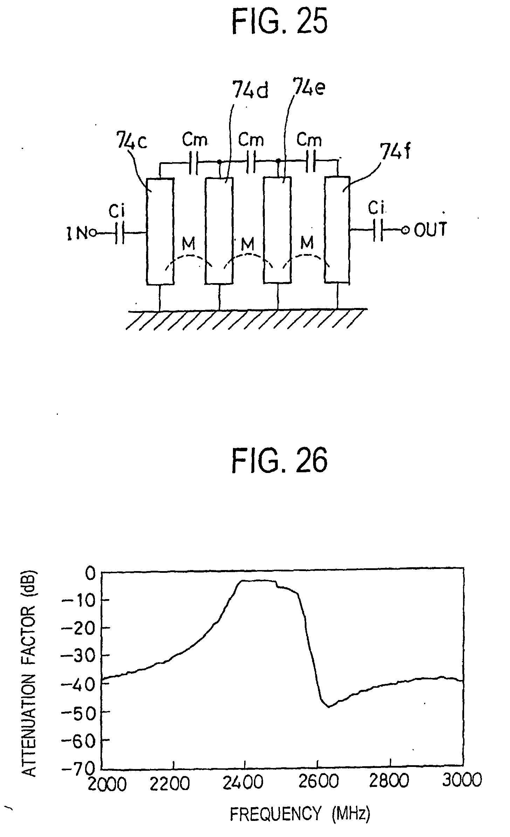

FIGS. 23 to 26 illustrate a multilayer filter according to a tenth embodiment of the invention. FIG. 23 is a perspective view, FIG. 24 is an exploded perspective view, FIG. 25 is an equivalent circuit diagram, and FIG. 26 is a transmission diagram. The multilayer filter is constructed as having four poles.

In FIGS. 23 to 26, the multilayer filter 60 includes a stack of constituent layers 60a to 60e, four strip lines 68 and a pair of capacitor conductors 67 both disposed approximately at the center of the stack. The remaining components are the same as in Example 9. The same components are designated by like numerals and their description is omitted.

Example 11

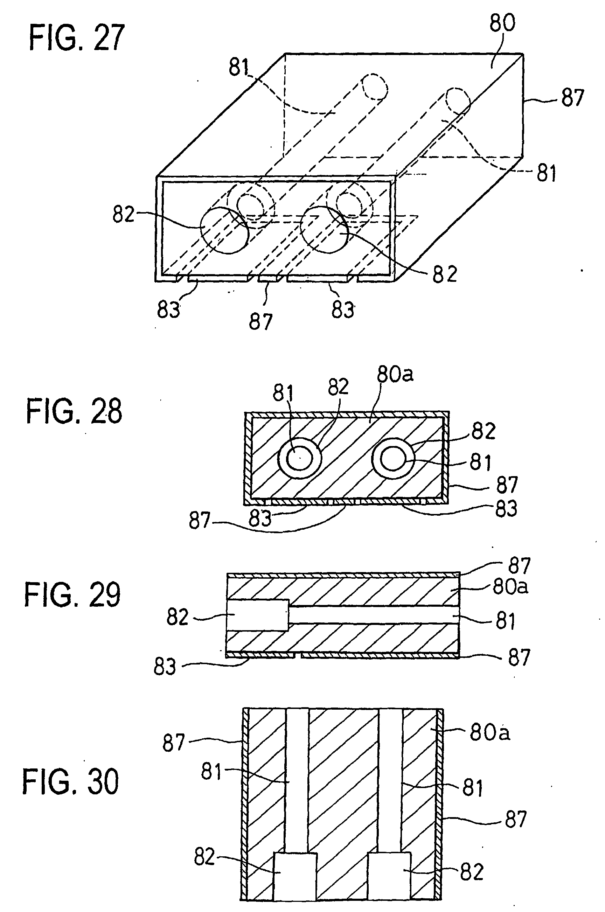

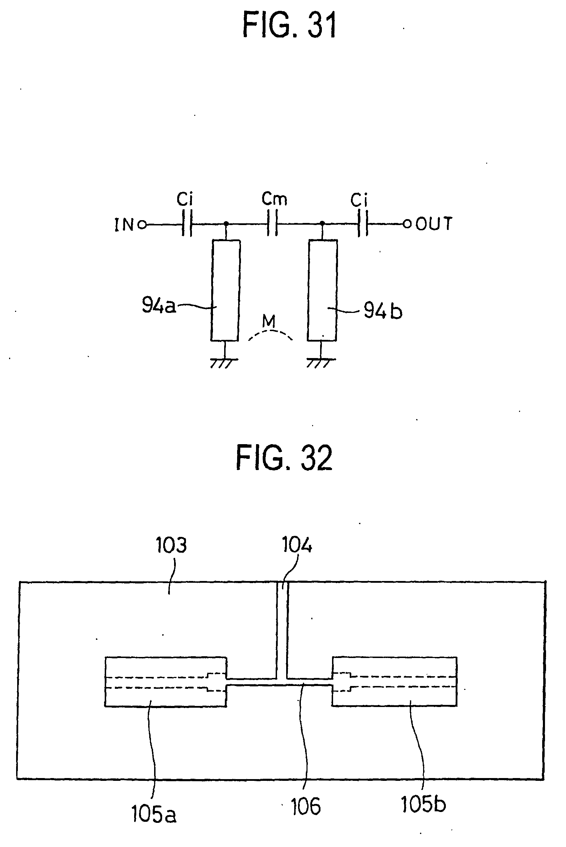

FIGS. 27 to 32 illustrate a block filter according to an 11th embodiment of the invention. FIG. 27 is a see-through perspective view, FIG. 28 is a front view, FIG. 29 is a cross-sectional elevational view, FIG. 30 is a cross-sectional plan view, FIG. 31 is an equivalent circuit diagram, and FIG. 32 is see-through elevational view illustrating the structure of the mold. It is to be noted that this block filter is constructed as having two poles.

In FIGS. 27 to 32, the block filter 80 comprises a pair of coaxial conductors 81 and capacitor coaxial conductors 82 formed in a constituent block 80a. The coaxial conductors 81 and the capacitor coaxial conductors 82 are constituted by the conductors formed in the shape of hollow body extending through the constituent block 80a. The constituent block 80a is covered by a surface GND conductor 87 which surrounds the constituent block 80a. Capacitor conductors 83 are formed at the positions corresponding to the capacitor coaxial conductors 82. The capacitor conductors 83 and the surface GND conductor 87 are also used as an input/output terminal or a part-securing terminal. The coaxial conductors 81 and the capacitor coaxial conductors 82 are formed by depositing a conductive material on the interior of the hollow hole extending through the constituent block 80a by means of electroless plating, evaporation, or the like to thereby form a transmission line.

The coaxial conductors 81 are coaxial lines 94a, 94b having a length of $\lambda g/4$ or shorter as shown in the equivalent circuit of FIG. 31, and a GND conductor 87 is formed to surround the coaxial conductors 81. The capacitor coaxial conductors 82 and the capacitor conductor 83 constitute input and output coupling capacitances Ci. The coaxial conductors 81 are coupled by a coupling capacitance Cm and a coupling coefficient M. Such constitution results in the equivalent circuit as shown in FIG. 31, and a block filter having transmission characteristics of the two pole type as shown in FIG. 31 is thus obtained.

FIG. 32 is a schematic cross-sectional view of a typical mold used in forming the constituent block 80a of the block filter 80. In FIG. 32, the mold comprises a metal base 103 comprising iron or the like formed with a resin gate 104 and a runner 106, and cavities 105a and 105b in connection with the resin gate 104 and the runner 106. The composite resin material for the constituent block 80a in liquid state is injected from the resin gate 104, and the material proceeds through the runner 106 into the cavities 105a and 105b. After cooling/heating the mold with the composite resin material filled in its interior, the solidified composite resin material is removed from the mold, and the unnecessary part formed by the curing in the resin inlet and the like is cut off for removal. The constituent block 80a as shown in FIG. 27 to 30 is thereby formed.

The surface GND conductor 87, the coaxial conductor 81, and the capacitor coaxial conductor 82, and the like may be formed on the thus produced constituent block 80a from copper, gold, palladium, platinum, aluminum or the like by effecting suitable treatment such as plating, termination, printing, sputtering or evaporation.

The constituent block 80a of the block filter 80 at least comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

The composite dielectric material exhibits desired transmission characteristics in a frequency band of several hundreds of megahertz to several gigahertz when the constituent block 80a of the block filter 80 has a dielectric constant of 2.6 to 40. It is desired to minimize the material loss of the coaxial resonator, and hence, setting a dielectric dissipation factor (tan$\delta$) in the range of 0.0025 to 0.0075 is preferable.

Example 12

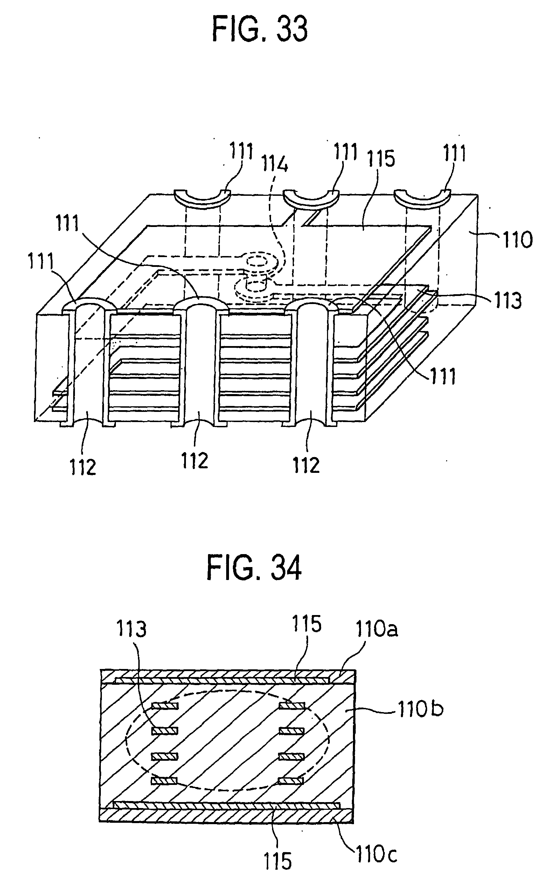

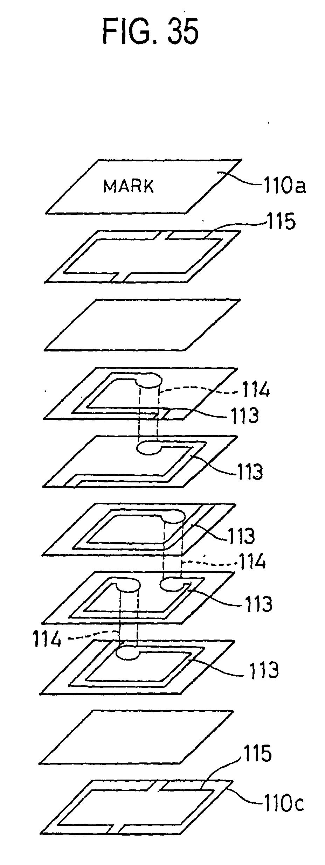

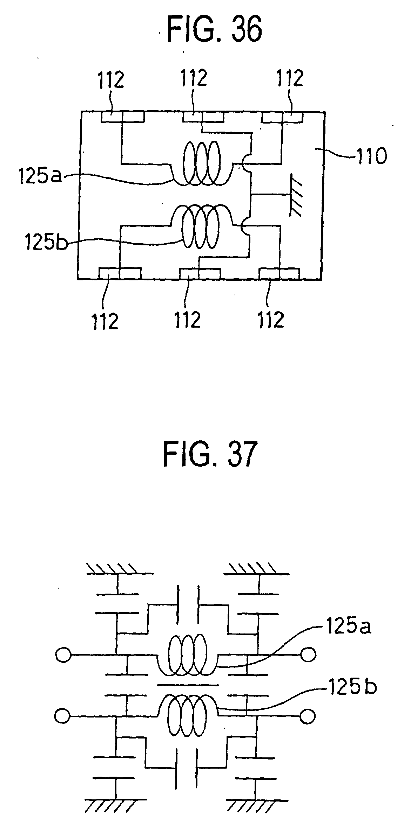

FIGS. 33 to 37 illustrate a coupler according to an 12th embodiment of the invention. FIG. 33 is a see-through perspective view, FIG. 34 is a cross-sectional view, FIG. 35 is an exploded perspective view of respective constituent layers, FIG. 36 is a diagram of internal connection, and FIG. 37 is an equivalent circuit diagram.

In FIGS. 33 to 37, the coupler 110 includes a stack of constituent layers 110a to 110c, internal GND conductors 115 formed and disposed on the top and bottom of the stack, and internal conductors 113 formed between the internal GND conductors 115. The internal conductors 113 are connected by via holes 114 in a spiral fashion so that two coils construct a transformer. Ends of the thus formed coils and internal GND conductors 115 are connected to through-vias 112 formed on end sides and land patterns 111 formed slightly above or below the through-vias 112 as shown in FIG. 36. With the above construction, a coupler 110 having two coils 125a and 125b coupled is obtained as shown in the equivalent circuit diagram of FIG. 37.

At least one of the constituent layers 110a to 110c of the coupler 110 comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

Where a wide band is to be realized, the composite dielectric material should preferably have a minimized dielectric constant. For size reduction, on the other hand, a higher dielectric constant is desirable. Therefore, depending on the intended application, required performance and specifications, a material having an appropriate dielectric constant may be used. In most cases, setting a dielectric constant in the range of 2.6 to 40 ensures desired transmission characteristics in a band of several hundreds of megahertz to several gigahertz. For increasing the Q value of an internal inductor, a dielectric dissipation factor (tan$\delta$) of 0.0025 to 0.0075 is preferable. This choice enables to form an inductor having a minimized material loss and a high Q value, leading to a high performance coupler. The respective constituent layers may be identical or different and an optimum combination thereof may be selected.

Example 13

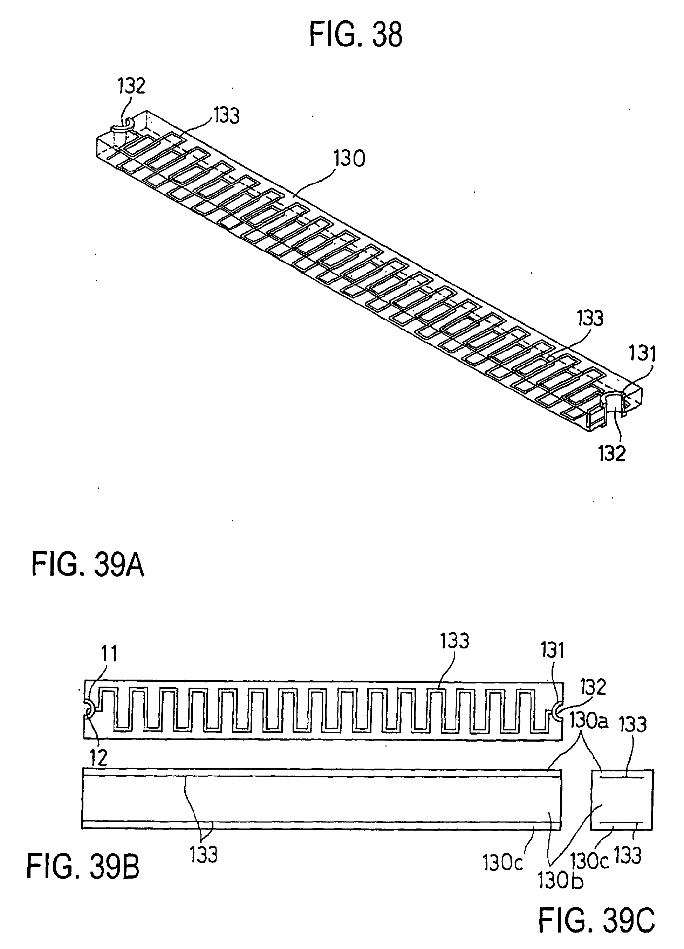

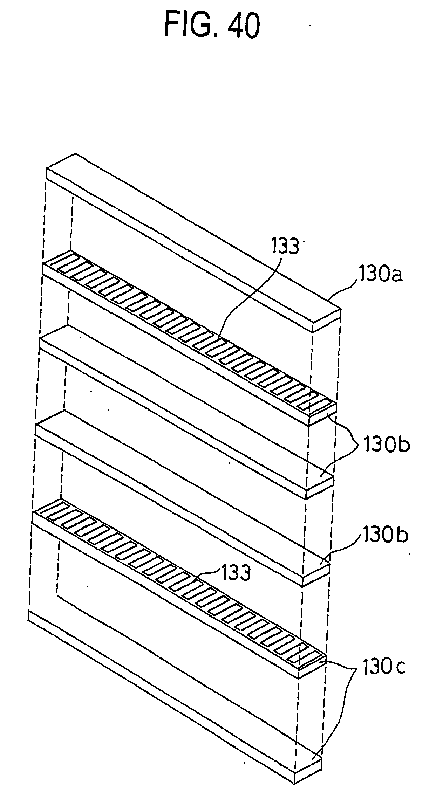

FIGS. 38 to 40 illustrate an antenna according to a 13th embodiment of the invention. FIG. 38 is a see-through perspective view, FIG. 39A is a plan view, FIG. 39B is a cross-sectional elevational view, FIG. 39C is a cross-sectional end view, and FIG. 40 is an exploded perspective view of respective constituent layers.

In FIGS. 38 to 40, the antenna 130 includes a stack of constituent layers (prepregs or substrates) 130a to 130c, and internal conductors (antenna patterns) 133 formed on constituent layers 130b and 130c. Ends of the internal conductors 133 are connected to through-vias 132 formed at end sides of the antenna and land patterns 131 formed slightly above and below the through-vias 132. In this example, the internal conductor 133 is constructed as a reactance element having a length of about λg/4 at the operating frequency and formed in a meander fashion.

At least one of the constituent layers 130a to 130c of the antenna 130 comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized form.

Where a wide band is to be realized, the composite dielectric material should preferably have a minimized dielectric constant. For size reduction, on the other hand, a higher dielectric constant is desirable. Therefore, depending on the intended application, required performance and specifications, a material having an appropriate dielectric constant may be used. In most cases, a dielectric constant in the range of 2.6 to 40 and a dielectric dissipation factor of 0.0025 to 0.025 are preferable. This choice enables to spread the frequency range and increase the precision of formation. It is also necessary to minimize the material loss. By setting a dielectric dissipation factor (tanδ) at 0.0025 to 0.025, an antenna having a minimum material loss is achievable. In another application, it is preferable to have a magnetic permeability of 3 to 20. The respective constituent layers may be identical or different and an optimum combination thereof may be selected.

Example 14

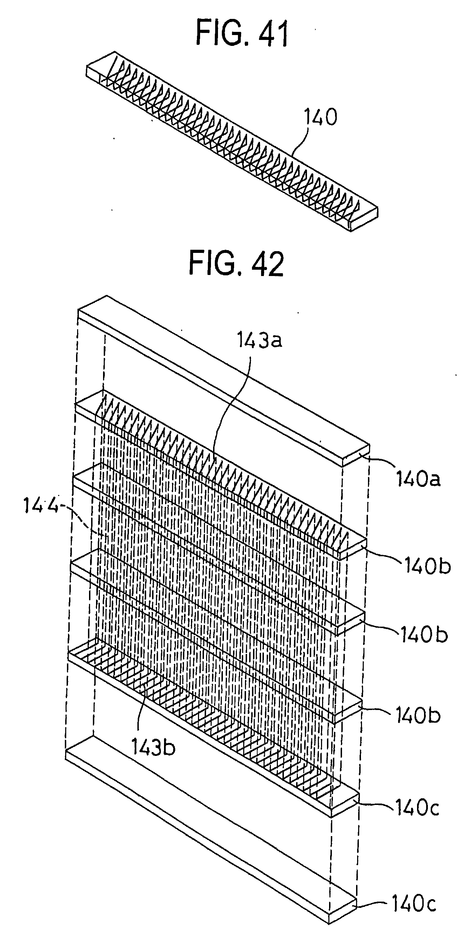

FIGS. 41 and 42 illustrate an antenna according to a 14th embodiment of the invention. FIG. 41 is a see-through perspective view, and FIG. 42 is an exploded perspective view of respective constituent layers. The antenna in this example is constructed as an antenna having a helical internal electrode.

In FIGS. 41 and 42, the antenna 140 includes a stack of constituent layers (prepregs or substrates) 140a to 140c comprising the resin material of the invention, and internal conductors (antenna patterns) 143a, 143b formed on constituent layers 140b and 140c. The upper and lower internal conductors 143a and 143b are connected by via holes 144 to form a helical inductance device. The remaining components are the same as in Example 13. The same components are designated by like numerals and their description is omitted.

Example 15

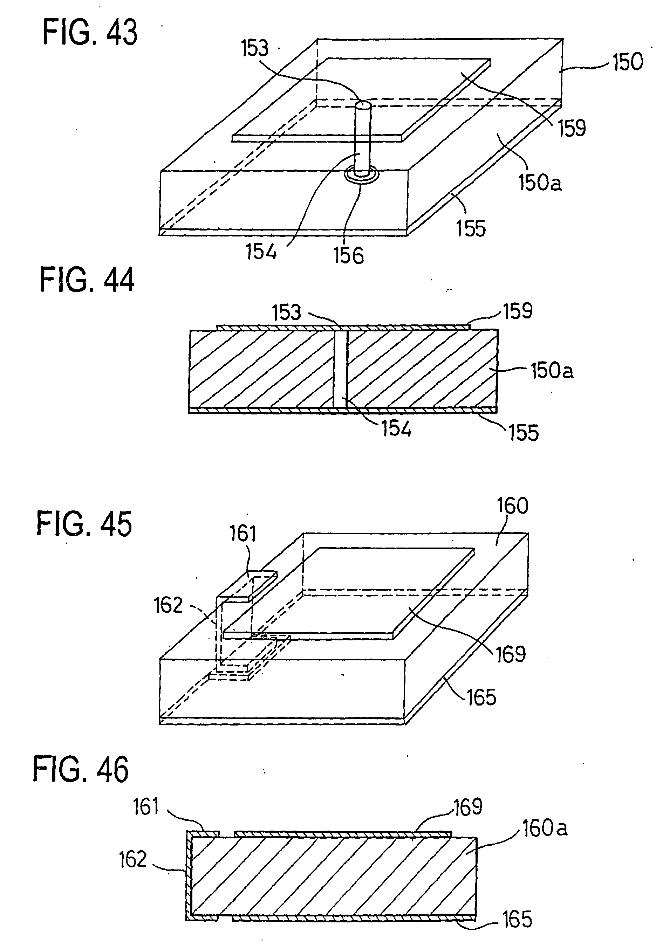

FIGS. 43 and 44 illustrate a patch antenna according to a 15th embodiment of the invention. FIG. 43 is a see-through perspective view, and FIG. 44 is a cross-sectional view.

In FIGS. 43 and 44, the patch antenna 150 includes a constituent layer (prepreg or substrate) 150a of composite resin material of the invention, a patch conductor (antenna pattern) 159 formed on the top of constituent layer 150a, and a GND conductor 155 formed on the bottom of constituent layer 150a so as to oppose to the patch conductor 159. A power supply through conductor 154 is connected to the patch conductor 159 at a power supply site 153. An annular gap 156 is provided between the through conductor 154 and the GND conductor 155 so that the through conductor 154 may not be connected to the GND conductor 155. Then power supply is provided from below the GND conductor 155 via the through conductor 154.

The constituent layer 150a of the patch antenna 150 comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized form.

Where a wide band is to be realized, composite dielectric material should preferably have a minimized dielectric constant. For size reduction, on the other hand, a higher dielectric constant is desirable. Therefore, depending on the intended application, required performance and specifications, a material having an appropriate dielectric constant may be used. In most cases, a dielectric constant in the range of 2.6 to 40 and a dielectric dissipation factor of 0.0025 to 0.025 are preferable. This choice enables to spread the frequency range and increase the precision of formation. It is also necessary to minimize the material loss. By setting a dielectric dissipation factor (tanδ) of 0.0025 to 0.025, an antenna having a minimum material loss and a high radiation efficiency is achievable.

In a frequency band of less than several hundreds of megahertz, a magnetic material exerts a wavelength reducing effect as a dielectric material does, which enables to increase the inductance of a radiation element. By matching the frequency peak of Q, a high Q value is available even at a relatively low frequency. Then a magnetic permeability of 3 to 20 is preferable in some applications. This enables performance improvement and size reduction in a frequency band of less than several hundreds of megahertz. The respective constituent layers may be identical or different and an optimum combination thereof may be selected.

Example 16

FIGS. 45 and 46 illustrate a patch antenna according to a 16th embodiment of the invention. FIG. 45 is a see-through perspective view, and FIG. 46 is a cross-sectional view.

In FIGS. 45 and 46, the patch antenna 160 includes a constituent layer (prepreg or substrate) 160a of composite resin material of the invention, a patch conductor (antenna pattern) 169 formed on the top of constituent layer 160a, and a GND conductor 165 formed on the bottom of constituent layer 160a so as to oppose to the patch conductor 169. A power supply conductor 161 is provided near the patch conductor 169, but spaced therefrom. Power supply is provided to the power supply conductor 161 via a power supply terminal 162. The power supply terminal 162 may be formed from copper, gold, palladium, platinum, aluminum or the like by effecting suitable treatment such as plating, termination, printing, sputtering or evaporation. The remaining components are the same as in Example 15. The same components are designated by like numerals and their description is omitted.

Example 17

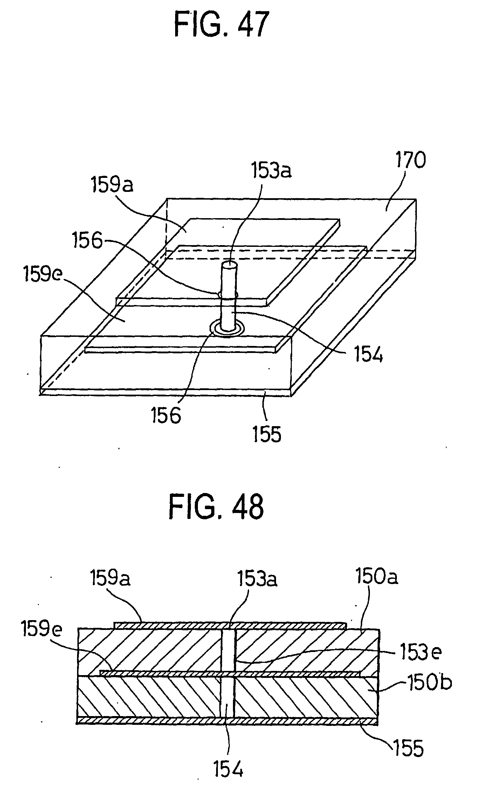

FIGS. 47 and 48 illustrate a patch antenna according to a 17th embodiment of the invention. FIG. 47 is a see-through perspective view, and FIG. 48 is a cross-sectional view.

In FIGS. 47 and 48, the patch antenna 170 includes constituent layers (prepregs or substrates) 150a, 150b of composite resin materials, patch conductors 159a, 159e formed on the constituent layers 150a, 150b, and a GND conductor 155 formed on the bottom of constituent layer 150b so as to oppose to the patch conductors 159a, 159e. A power supply through conductor 154 is connected to the patch conductor 159a at a power supply site 153a. A gap 156 is provided between the through conductor 154 and the GND conductor 155 and patch conductor 159e so that the through conductor 154 may not be connected to the GND conductor 155 and patch conductor 159e. Then power supply is provided to the patch conductor 159a from below the GND conductor 155 via the through conductor 154. At this point, power supply is provided to the patch conductor 159e by the capacitive coupling with the patch conductor 159a and the capacitance due to the gap with the through conductor 154. The remaining components are the same as in Example 15. The same components are designated by like numerals and their description is omitted.

Example 18

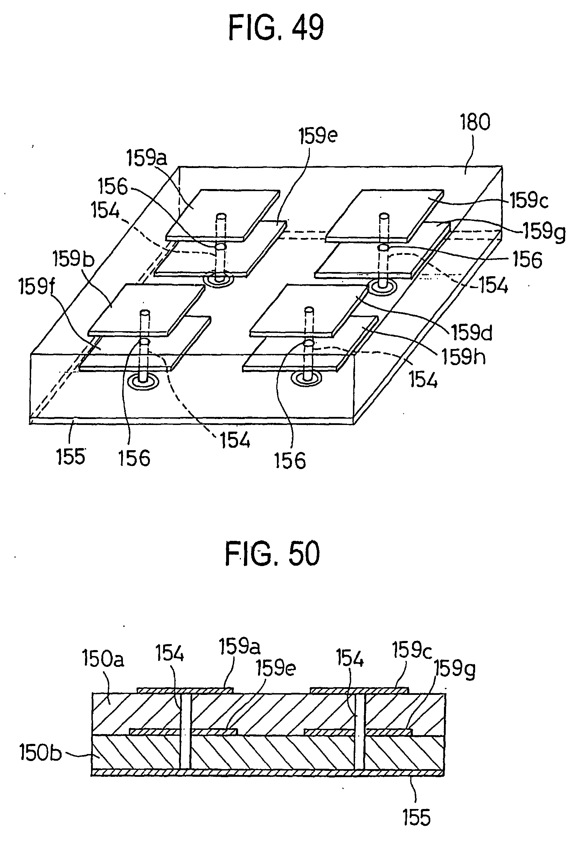

FIGS. 49 and 50 illustrate a multi-array patch antenna 180 according to a 18th embodiment of the invention. FIG. 49 is a see-through perspective view, and FIG. 50 is a cross-sectional view.

As opposed to Example 17 in which the patch antenna is constructed singly, four patch antennas are arranged in an array in this example. In FIGS. 49 and 50, the array includes constituent layers 150a, 150b of composite resin materials, patch conductors 159a, 159b, 159c, 159d formed on the constituent layer 150a, patch conductors 159e, 159f, 159g, 159h formed on the constituent layer 150b, and a GND conductor 155 formed on the bottom of the constituent layer 150b so as to oppose to the patch conductors 159a, 159e. The remaining components are the same as in Example 18. The same components are designated by like numerals and their description is omitted.

The array formation enables to reduce the size of a set and the number of parts.

Example 19

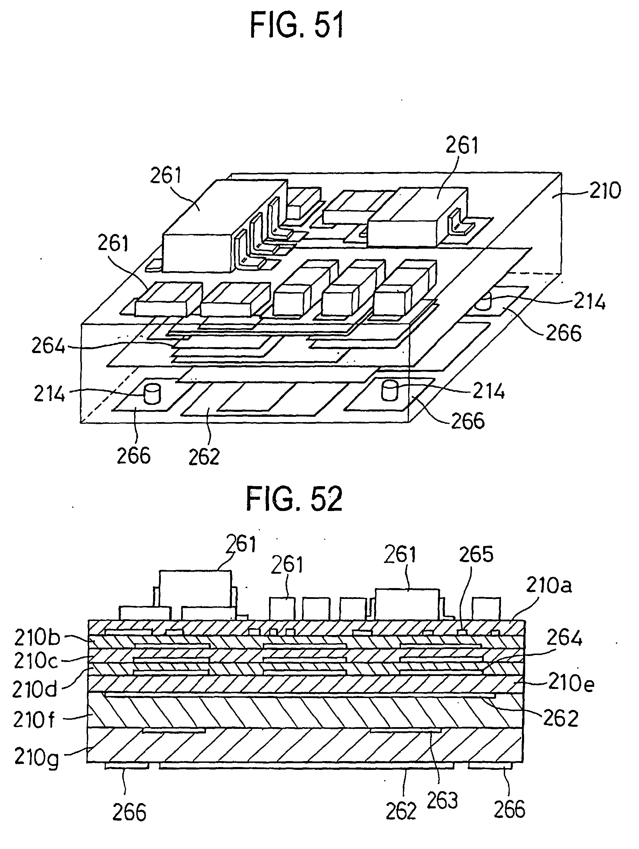

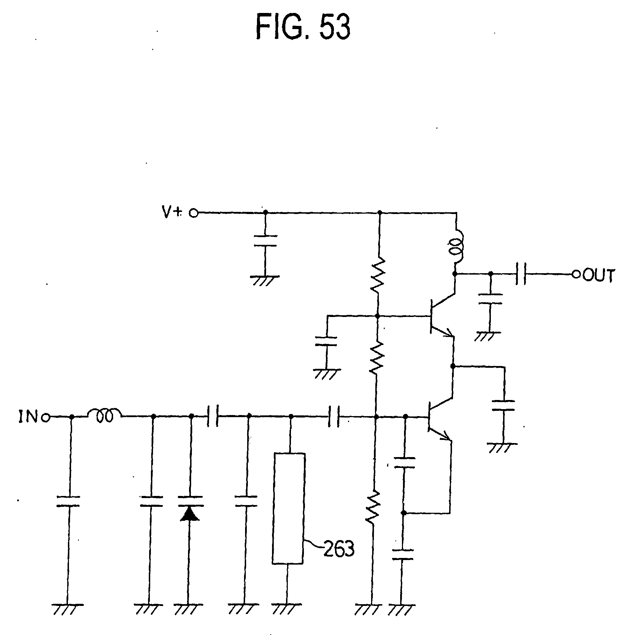

FIGS. 51 to 53 illustrate a voltage controlled oscillator (VCO) according to an 19th embodiment of the invention. FIG. 51 is a see-through perspective view, FIG. 52 is a cross-sectional view, and FIG. 53 is an equivalent circuit diagram.

In FIGS. 51 to 53, the VCO includes a stack of constituent layers 210a to 210g of composite resin materials, electronic parts 261 disposed and formed on the stack including capacitors, inductors, semiconductors and registers, and conductor patterns 262, 263, 264 formed above, below and intermediate the constituent layers 210a to 210g. Since the VCO is constructed to an equivalent circuit as shown in FIG. 53, it further includes strip lines 263, capacitors, signal lines, semiconductors and power supply lines. It is advantageous to form the respective constituent layers from materials selected appropriate for their function.

In this case, at least one of the constituent layers 210a to 210g comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

For the constituent layers 210f, 210g constructing a resonator in this example, it is preferred to use dielectric layers having a dielectric dissipation factor of 0.0025 to 0.0075. For the constituent layers 210c to 210e constructing a capacitor, it is preferred to use composite dielectric layers so as to give a dielectric dissipation factor of 0.0075 to 0.025 and a dielectric constant of 5 to 40. For wiring and the constituent layers 210a, 210b constructing an inductor, it is preferred to use dielectric layers having a dielectric dissipation factor of 0.0025 to 0.0075 and a dielectric constant of 2.6 to 5.0.

On the surface of constituent layers 210a to 210g, there are provided internal conductors including strip line 263, GND conductor 262, capacitor conductor 264, wiring inductor conductor 265 and terminal conductor 266. Upper and lower internal conductors are connected by via holes 214. Electronic parts 261 are mounted on the surface, completing a VCO corresponding to the equivalent circuit of FIG. 53.

This construction enables to provide an appropriate dielectric constant, Q and dielectric dissipation factor for a distinct function, arriving at a high performance, small size, and thin part.

Example 20

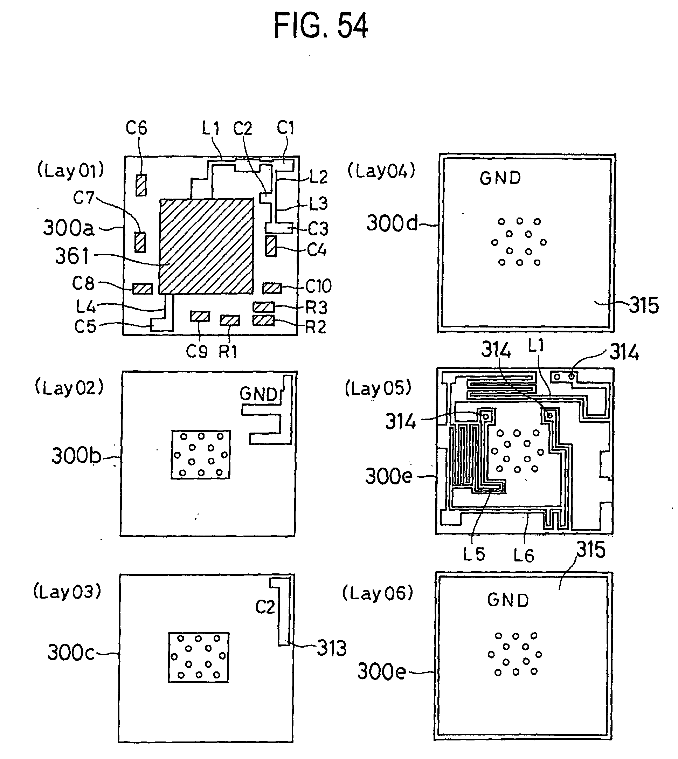

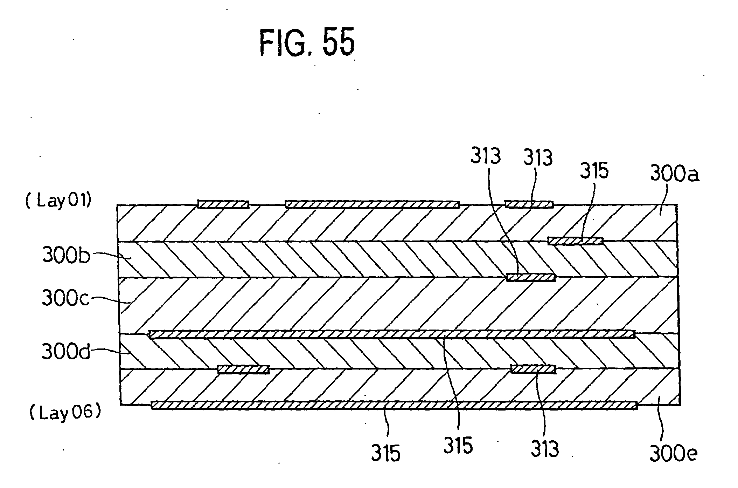

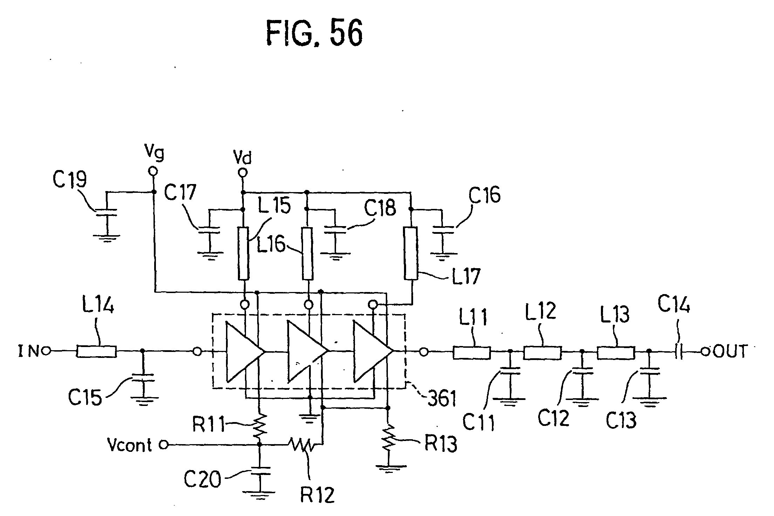

FIGS. 54 to 56 illustrate a power amplifier according to a 20th embodiment of the invention. FIG. 54 is an exploded plan view of respective constituent layers, FIG. 55 is a cross-sectional view, and FIG. 56 is an equivalent circuit diagram.

In FIGS. 54 to 56, the power amplifier includes a stack of constituent layers 300a to 300e, electronic parts 361 formed thereon including capacitors, inductors, semiconductors and registers, and conductor patterns 313, 315 formed above, below and intermediate the constituent layers 300a to 300e. Since the power amplifier is constructed to an equivalent circuit as shown in FIG. 56, it further includes strip lines L11 to L17, capacitors C11 to C20, signal lines, and power supply lines to semiconductor devices. It is advantageous to form the respective constituent layers from materials selected appropriate for their function.

In this case, at least one of the constituent layers comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized forms.

For the constituent layers 300d, 300e constructing strip lines in this example, it is preferred to use composite dielectric layers having a dielectric dissipation factor of 0.0075 to 0.025 and a dielectric constant of 2.6 to 40. For the constituent layers 300a to 300c constructing a capacitor, it is preferred to use composite dielectric layers so as to give a dielectric dissipation factor of 0.0025 to 0.025 and a dielectric constant of 5 to 40.

On the surface of constituent layers 300a to 300e, there are provided internal conductors 313, GND conductors 315, and the like. Upper and lower internal conductors are connected by via holes 314. Electronic parts 361 are mounted on the surface, completing a power amplifier corresponding to the equivalent circuit of FIG. 56.

This construction enables to provide an appropriate dielectric constant, Q and dielectric dissipation factor for a distinct function, arriving at a high performance, small size, and thin part.

Example 21

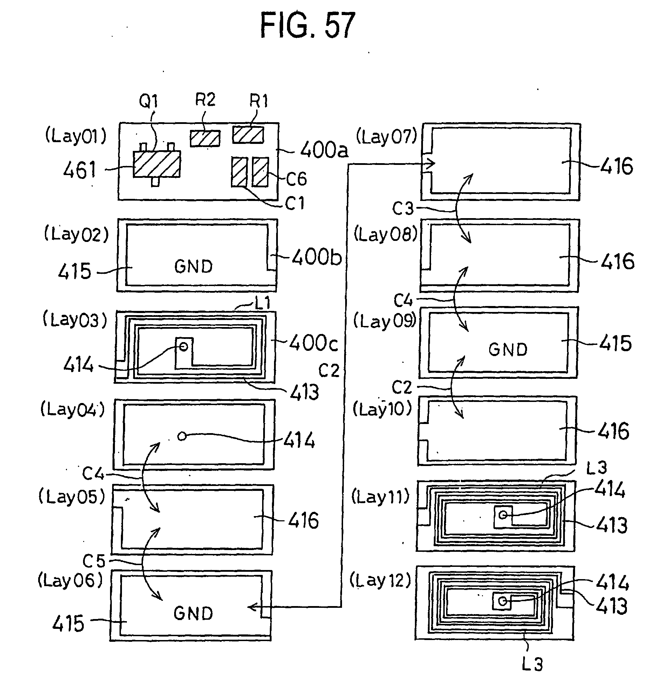

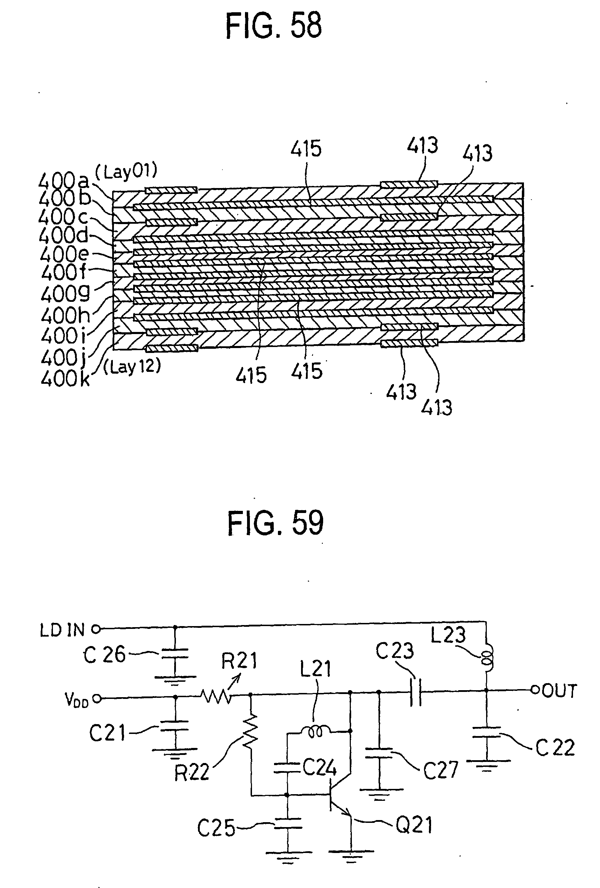

FIGS. 57 to 59 illustrate a superposed module according to a 21st embodiment of the invention, the module finding use as an optical pickup or the like. FIG. 57 is an exploded plan view of respective constituent layers, FIG. 58 is a cross-sectional view, and FIG. 59 is an equivalent circuit diagram.

In FIGS. 57 to 59, the superposed module includes a stack of constituent layers 400a to 400k, electronic parts 461 formed thereon including capacitors, inductors, semiconductors and registers, and conductor patterns 413, 415 formed above, below and intermediate the constituent layers 400a to 400k. Since the superposed module is constructed to an equivalent circuit as shown in FIG. 59, it further includes inductors L21, L23, capacitors C21 to C27, signal lines, and power supply lines to semiconductor devices. It is advantageous to form the respective constituent layers from materials selected appropriate for their function.

In this case, at least one of the constituent layers 400a to 400k comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized form.

For the constituent layers 400d to 400h constructing capacitors in this example, it is preferred to use composite dielectric layers so as to give a dielectric dissipation factor of 0.0075 to 0.025 and a dielectric constant of 10 to 40. For the constituent layers 400a to 400c and 400j to 400k constructing inductors, it is preferred to use composite dielectric layers having a dielectric dissipation factor of 0.0025 to 0.0075 and a dielectric constant of 2.6 to 5.0.

On the surface of constituent layers 400a to 400k, there are provided internal conductors 413, GND conductors 415, and the like. Upper and lower internal conductors are connected by via holes 414. Electronic parts 461 are mounted on the surface, completing a superposed module corresponding to the equivalent circuit of FIG. 59.

This construction enables to provide an appropriate dielectric constant, Q and dielectric dissipation factor for a distinct function, arriving at a high performance, small size, and thin part.

Example 22

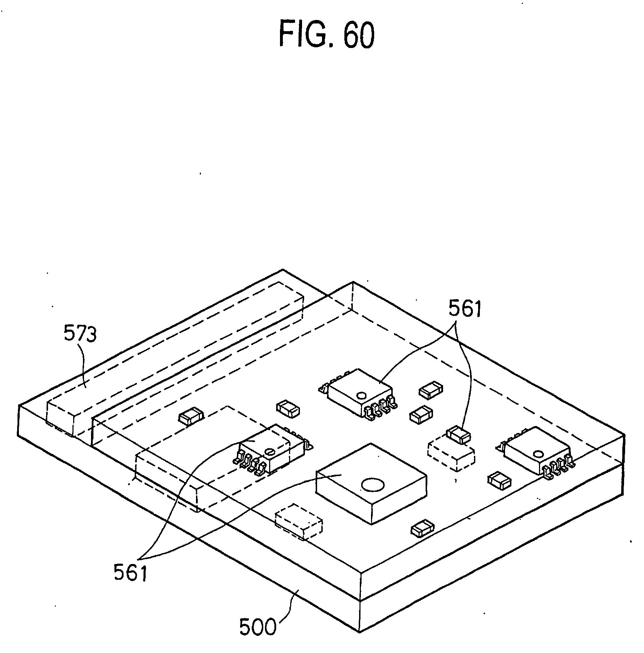

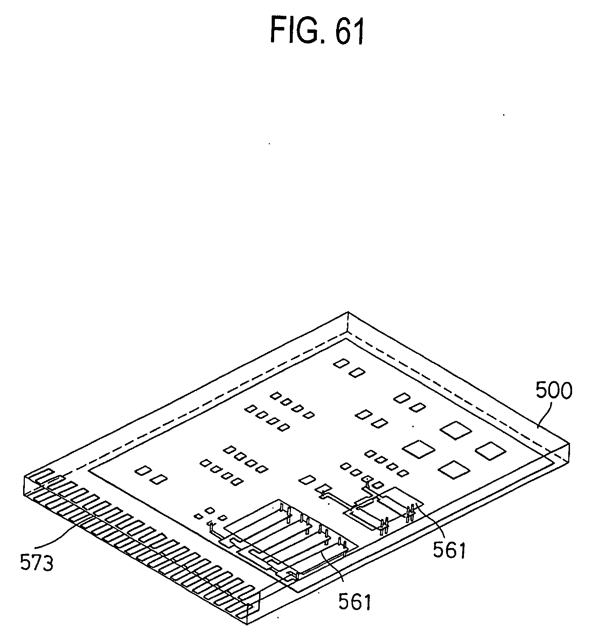

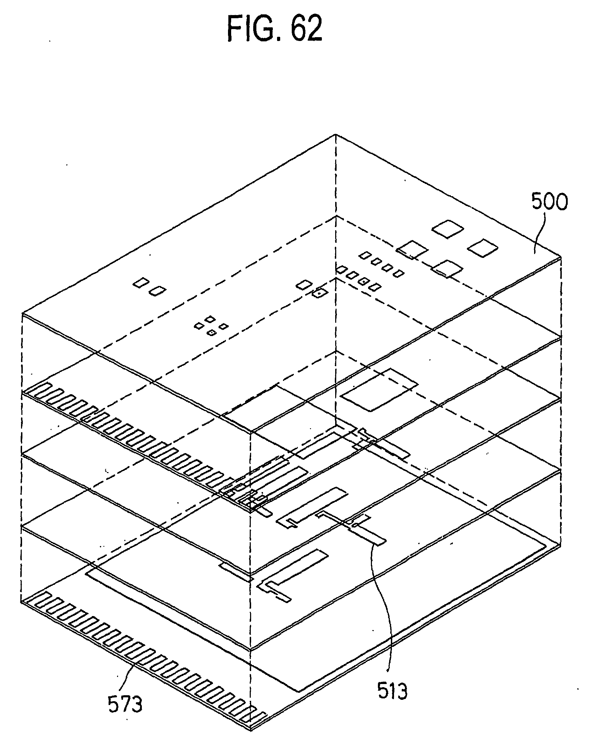

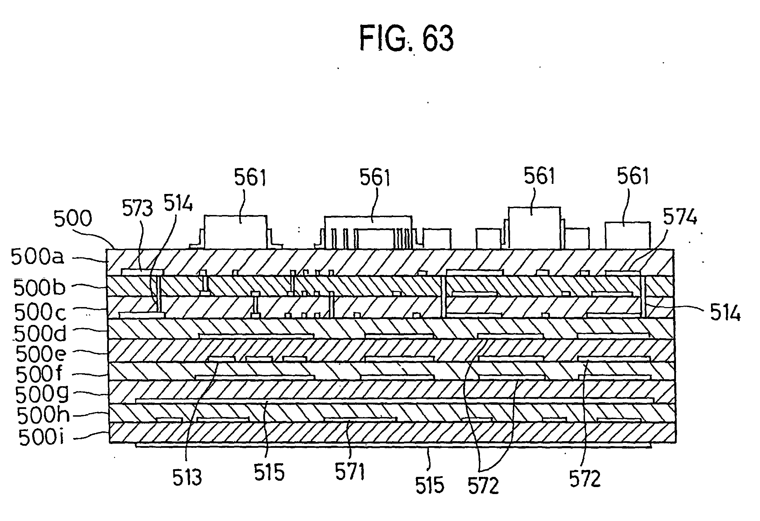

FIGS. 60 to 63 illustrate a RF module according to a 22nd embodiment of the invention. FIG. 60 is a perspective view, FIG. 61 is a perspective view with an outer housing removed, FIG. 62 is an exploded perspective view of respective constituent layers, and FIG. 63 is a cross-sectional view.

In FIGS. 60 to 63, the RF module includes a stack of constituent layers 500a to 500i, electronic parts 561 formed and disposed thereon including capacitors, inductors, semiconductors and registers, conductor patterns 513, 515, 572 formed above, below and intermediate the constituent layers 500a to 500i, and an antenna pattern 573. As mentioned just above, the RF module includes inductors, capacitors, signal lines, and power supply lines to semiconductor devices. It is advantageous to form the respective constituent layers from materials selected appropriate for their function.

In this case, at least one of the constituent layers 500a to 500i comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized form.

For the constituent layers 500a to 500d, 500g constructing the antenna, strip lines and wiring in this example, it is preferred to use composite dielectric layers having a dielectric dissipation factor of 0.0025 to 0.0075 and a dielectric constant of 2.6 to 5.0. For the constituent layers 500e to 500f constructing capacitors, it is preferred to use composite dielectric layers so as to give a dielectric dissipation factor of 0.0075 to 0.025 and a dielectric constant of 10 to 40. For the constituent layers 500h to 500i constructing the power supply line, it is preferred to use composite dielectric layers having a magnetic permeability of 3 to 20.

On the surface of constituent layers 500a to 500i, there are provided internal conductors 513, GND conductors 515, antenna conductors 573, and the like. Upper and lower internal conductors are connected by via holes 514. Electronic parts 561 are mounted on the surface, completing a RF module.

This construction enables to provide an appropriate dielectric constant, Q and dielectric dissipation factor for a distinct function, arriving at a high performance, small size, and thin part.

Example 23

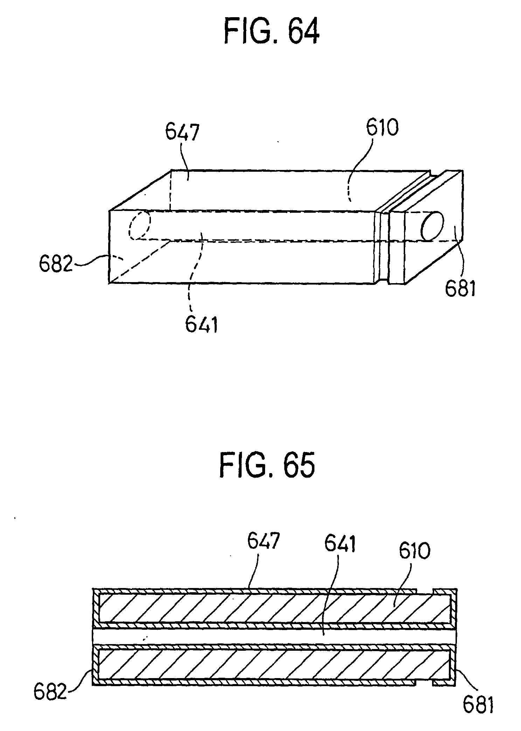

FIGS. 64 and 65 illustrate a resonator according to a 23rd embodiment of the invention. FIG. 64 is a see-through perspective view, and FIG. 65 is a cross-sectional view.

In FIGS. 64 and 65, the resonator comprises a base material 610 formed with a coaxial conductor 641 extending therethrough. The coaxial conductor 641 may be formed as in the case of the block filter of Example 11. To be more specific, a surface GND conductor 647, a coaxial conductor 641 connected to the surface GND conductor 647 by a terminal electrode 682, a HOT terminal 681 for a resonator connected to the coaxial conductor 641, and the like may be formed on the base material 610 which had been formed in a mold, from copper, gold, palladium, platinum, aluminum or the like by effecting suitable treatment such as plating, termination, printing, sputtering or evaporation. The coaxial conductor 641 is a coaxial line having a particular characteristic impedance, and the surface GND conductor 647 is formed to surround the coaxial conductor 641.

The base material 610 of the resonator comprises a composite dielectric material wherein a dielectric material is dispersed in a resin, and at least the dielectric material has a circular, oblate circular or oval projection shape, and in particular, has a mean particle size of 1 to 50 μm and a sphericity of 0.9 to 1.0. The composite dielectric material may further comprise a magnetic powder for adjustment of the magnetic characteristics, or the dielectric or magnetic material in pulverized form.

With respect to the base material 610 of the resonator, desired resonant characteristics are available in a band of several hundreds of megahertz to several gigahertz when the dielectric constant is in the range of 2.6 to 40. Since it is desired to minimize the material loss of the resonator, a dielectric dissipation factor (tanδ) of 0.001 to 0.0075 is preferred.

Example 24

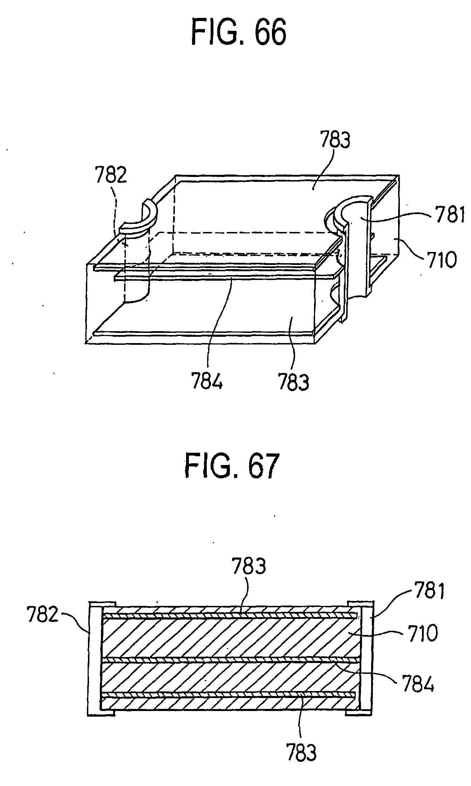

FIGS. 66 and 67 illustrate a strip resonator according to a 24th embodiment of the invention. FIG. 66 is a see-through perspective view, and FIG. 67 is a cross-sectional view.

In FIGS. 66 and 67, the strip resonator includes an intermediate rectangular strip conductor 784, upper and lower rectangular GND conductors 783, and constituent layers 710 sandwiched therebetween. To the opposite ends of the strip conductor 784, a HOT terminal 781 and a GND terminal 782 for a resonator are formed and connected. The method of forming the remaining components is the same as in the inductor of Example 1.

The constituent layer 710 of the resonator comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

With respect to the composite dielectric material, desired resonant characteristics are available in a band of several hundreds of megahertz to several gigahertz when the dielectric constant is in the range of 2.6 to 40. Since it is desired to minimize the material loss of the resonator, a dielectric dissipation factor (tan$\delta$) of 0.001 to 0.0075 is preferred.

Example 25

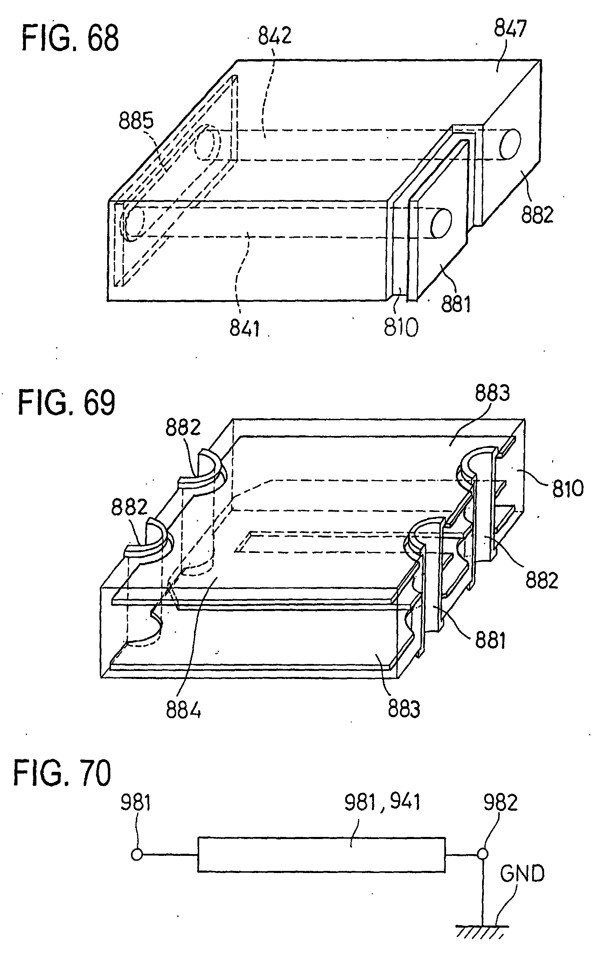

FIG. 68 is a see-through perspective view of a strip resonator according to a 25th embodiment of the invention.

In FIG. 68, the resonator comprises a base material 810 formed with two coaxial conductors 841 and 842 extending therethrough as in the case of Example 23. A surface GND conductor 847, a coaxial conductor 842 connected to the surface GND conductor 847 by a terminal electrode 882, a coaxial conductor 841 connected to the coaxial conductor 842 by a connection electrode 885, a HOT terminal 881 for a resonator connected to the coaxial conductor 841, and the like may be formed thereon. The coaxial conductors 841 and 842 are respectively coaxial lines having a particular characteristic impedance, and the surface GND conductor 847 is formed to surround the coaxial conductors 841 and 842.

The base material 810 of the resonator comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

With respect to the composite dielectric material, desired resonant characteristics are available in a band of several hundreds of megahertz to several gigahertz when the dielectric constant is in the range of 2.6 to 40. Since it is desired to minimize the material loss of the resonator, a dielectric dissipation factor (tan$\delta$) of 0.001 to 0.0075 is preferred.

Example 26

FIG. 69 is a see-through perspective view of a strip resonator according to a 26th embodiment of the invention.

Like Example 24, the strip resonator in FIG. 69 includes an intermediate U-shaped strip conductor 884, upper and lower rectangular GND conductors 883, and constituent layers 810 sandwiched therebetween. To the opposite ends of the strip conductor 884, a HOT terminal 881 and a GND terminal 882 for a resonator are formed and connected. The method of forming the remaining components is the same as in the inductor of Example 1.

The constituent layer 810 of the resonator comprises a composite dielectric material wherein a dielectric material is dispersed in a resin, and at least the dielectric material has a circular, oblate circular or oval projection shape, and in particular, has a mean particle size of 1 to 50 $\mu$m and a sphericity of 0.9 to 1.0. The composite dielectric material may further comprise a magnetic powder for adjustment of the magnetic characteristics, or the dielectric or magnetic material in pulverized form.

With respect to the composite dielectric material, desired resonant characteristics are available in a band of several hundreds of megahertz to several gigahertz when the dielectric constant is in the range of 2.6 to 40. Since it is desired to minimize the material loss of the resonator, a dielectric dissipation factor (tan$\delta$) of 0.001 to 0.0075 is preferred.

FIG. 70 is an equivalent circuit diagram of the resonators in the foregoing Examples 23 and 26. In the diagram, a HOT terminal 981 for the resonator is connected to one end of a resonator 984, 941 constructed by a coaxial path or strip line, and a GND terminal 982 is connected to the other end thereof.

Example 27

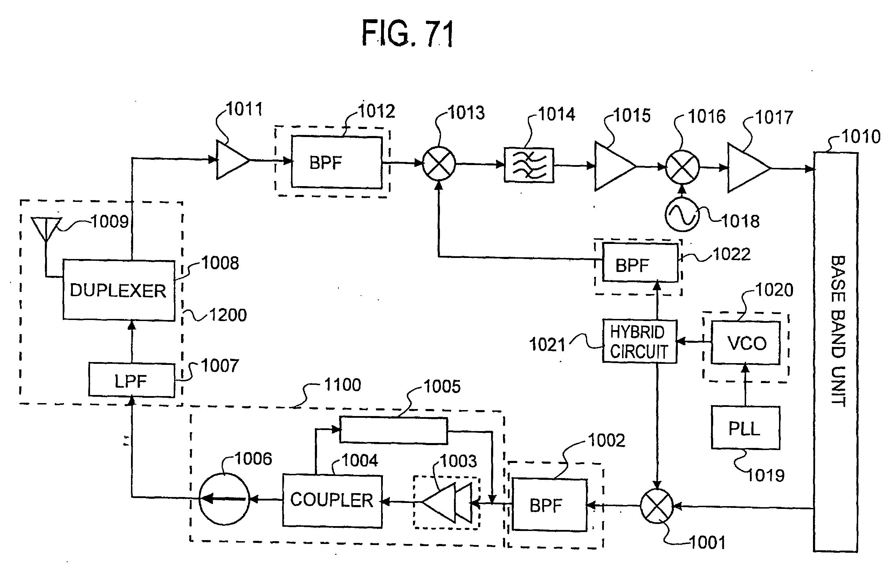

FIG. 71 is a block diagram showing a high-frequency portion of a portable terminal equipment according to a 27th embodiment of the invention.

In FIG. 71, a base band unit 1010 delivers a transmission signal to a mixer 1001 where the signal is mixed with an RF signal from a hybrid circuit 1021. A voltage controlled oscillator (VCO) 1020 is connected to the hybrid circuit 1021 to construct a synthesizer circuit with a phase lock loop circuit 1019 so that the hybrid circuit 1021 may deliver an RF signal of a predetermined frequency.

The transmission signal which has been RF modulated by the mixer 1001 is passed through a band-pass filter (BPF) 1002 and amplified by a power amplifier 1003. An output of the power amplifier 1003 is partially taken out of a coupler 1004, adjusted to a predetermined level by an attenuator 1005, and fed back to the power amplifier 1003 for adjusting so that the power amplifier may have a constant gain. The coupler 1004 delivers a transmission signal to a duplexer 1008 through an isolator 1006 for precluding reverse current and a low-pass filter 1007. The signal is transmitted from an antenna 1009 connected to the duplexer 1008.

An input signal received by the antenna 1009 is fed from the duplexer 1008 to an amplifier 1011 and amplified to a predetermined level. The received signal delivered from the amplifier 1011 is fed to a mixer 1013 through a band-pass filter 1012. The mixer 1013 receives an RF signal from the hybrid circuit 1021 whereby the RF signal component is removed to effect demodulation. The received signal delivered from the mixer 1013 is passed through a SAW filter 1014, amplified by an amplifier 1015, and fed to a mixer 1016. The mixer 1016 also receives a local transmission signal of a predetermined frequency from a local transmitter circuit 1018. The received signal is converted to a desired frequency, amplified to a predetermined level by an amplifier 1017 and sent to the base band unit.

According to the invention, an antenna front end module 1200 including the antenna 1009, duplexer 1008, and low-pass filter 1007, and an isolator power amplifier module 1100 including the isolator 1006, coupler 1004, attenuator 1005 and power amplifier 1003 can be constructed as a hybrid module by the same procedure as above. Further, a unit including other components can be constructed as an RF unit as demonstrated in Example 22. BPF, VCO, etc. can be constructed in accordance with the procedures shown in Examples 9 to 12 and 19.

In addition to the above-exemplified electronic parts, the invention is also applicable by a similar procedure to coil cores, troidal cores, disk capacitors, lead-through capacitors, clamp filters, common mode filters, EMC filters, power supply filters, pulse transformers, deflection coils, choke coils, DC-DC converters, delay lines, wave absorber sheet, thin wave absorber, electromagnetic shielding, diplexers, duplexers, antenna switch modules, antenna front end modules, isolator/power amplifier modules, PLL modules, front end modules, tuner units, directional couplers, double balanced mixers (DBM), power synthesizers, power distributors, toner sensors, current sensors, actuators, sounders (piezoelectric sound generators), microphones, receivers, buzzers, PTC thermistors, temperature fuses, ferrite magnets, etc.

In each of the foregoing Examples, any of flame retardants, for example, halides such as halogenated phosphates and brominated epoxy resins, organic compounds such as phosphate amides, and inorganic materials such as antimony trioxide and aluminum hydride may be added to the constituent layers.

MERITS OF THE INVENTION

As described above, the present invention has enabled to provide an electronic part which has a dielectric constant higher than that of the conventional materials, which does not suffer loss of strength, and which enjoys the advantages of small size, excellent performance and improved overall electrical characteristics; a substrate for an electronic part and an electronic part wherein the material used for the production exhibits reduced lot-to-lot variation in the electric properties, and in particular, in the dielectric constant, and wherein wearing of the mold in the production of the material has been suppressed; and a substrate for an electronic part and an electronic part which have a high withstand voltage.

**Claims**

1. A substrate for an electronic part comprising a composite dielectric material wherein said composite dielectric material has at least a dielectric material having a circular, oblate circular or oval projection shape dispersed in a resin.

2. A substrate for an electronic part according to claim 1 wherein said dielectric material having a projected image of circle has a mean particle size of 1 to 50 $\mu$m and a sphericity of 0.9 to 1.0.

3. A substrate for an electronic part according to claim 1 or 2 wherein said composite dielectric material further comprises a magnetic powder.

4. A substrate for an electronic part according to any one of claims 1 to 3 wherein said composite dielectric material further comprises a pulverized material.

**5.** A substrate for an electronic part according to any one of claims 1 to 4 wherein said composite dielectric material further comprises a glass cloth embedded in the material.

**6.** A substrate for an electronic part according to any one of claims 1 to 5 comprising two or more different composite dielectric materials.

**7.** A substrate for an electronic part according to any one of claims 1 to 6 comprising at least one composite dielectric material and one or more flame retardant.

**8.** An electronic part comprising the substrate for an electronic part of any one of claims 1 to 7.

## FIG. 1

## FIG. 2

# FIG. 3

# FIG. 4

## FIG. 5

## FIG. 6

FIG. 7

FIG. 8

FIG. 9

FIG. 10A

FIG. 10B

31a

31b

31c

31d

FIG. 11

FIG. 12

FIG. 13

FIG. 14A

FIG. 14B

FIG. 15

FIG. 16

# FIG. 17

# FIG. 18

53c

λg/4

λg/4

① UNBALANCE          ⑥ N.C          53a

53b

②⑤ GND          ②⑤ GND

53d

③ BALANCE          ④ BALANCE

# FIG. 19

66          60

61

62

66

# FIG. 20

# FIG. 21

# FIG. 22

## FIG. 23

## FIG. 24

# FIG. 25

# FIG. 26

FIG. 27

FIG. 28

FIG. 29

FIG. 30

# FIG. 31

IN○— Ci —●— Cm —●— Ci —○ OUT

94a | 94b

M

# FIG. 32

103    104

105a    106    105b

## FIG. 33

## FIG. 34

# FIG. 35

MARK 110a

115

114
113

113

113

114

113

114

113

115

110c

## FIG. 36

## FIG. 37

## FIG. 38

132    133    130    133    131    132

## FIG. 39A

11    133    131    132

12    130a    133

133    130c    130b    130c    133

FIG. 39B

## FIG. 39C

# FIG. 40

# FIG. 41

140

# FIG. 42

143a

140a

144

140b

140b

143b

140b

140c

140c

FIG. 43

FIG. 44

FIG. 45

FIG. 46

## FIG. 47

## FIG. 48

# FIG. 49

# FIG. 50

# FIG. 51

# FIG. 52

# FIG. 53

# FIG. 54

FIG. 55

# FIG. 56

EP 1 260 998 A1

## FIG. 57

# FIG. 58

# FIG. 59

# FIG. 60

573

561

561

500

# FIG. 61

# FIG. 62

FIG. 63

# FIG. 64

647    610

682    641    681

# FIG. 65

647    641    610

682    681

## FIG. 66

## FIG. 67

FIG. 68

842    847
885
882
881
841    810

FIG. 69

883
882
882    810
882
881
884    883

FIG. 70

981    981, 941    982
GND

# FIG. 71

EP 1 260 998 A1

FIG. 72A

FIG. 72B

FIG. 72C

FIG. 72D

## FIG. 73A

## FIG. 73B

## FIG. 73C

## FIG. 73D

# FIG. 74

PREPREG
↓

Cu FOIL → | STEP A: Cu FOIL LAMINATING PRESS |

↓

| STEP B: THROUGH-HOLE DRILLING |

↓

| STEP C: THROUGH-HOLE PLATING (Cu) |

↓

| STEP D: PATTERNING (BOTH SURFACES) |

↓

| STEP E: PLATING |

# FIG. 75

217

216

217

217

STEP A

217

216

217

STEP B

217

216

217

218

STEP C

217

216

217

225

226

STEP D

216

# FIG. 76

PREPREG
↓

Cu FOIL → | STEP A: Cu FOIL LAMINATING PRESS |

↓

STEP B: PATTERNING (BOTH SURFACES)

↓

Cu FOIL → | STEP C: Cu FOIL/PREPREG
SIMULTANEOUS LAMINATING PRESS | ← PREPREG

↓

STEP D: THROUGH-HOLE DRILLING

↓

STEP E: THROUGH-HOLE PLATING (Cu)

↓

STEP F: PATTERNING (BOTH SURFACES)

↓

STEP G: PLATING

# FIG. 77

STEP A

STEP B

STEP C

STEP D

STEP E

STEP F

## INTERNATIONAL SEARCH REPORT

| International application No. |
| --- |
| PCT/JP01/10055 |

**A. CLASSIFICATION OF SUBJECT MATTER**
Int.Cl⁷ H01G 4/20, H01B3/00

According to International Patent Classification (IPC) or to both national classification and IPC

**B. FIELDS SEARCHED**

Minimum documentation searched (classification system followed by classification symbols)
Int.Cl⁷ H01G 4/00-4/40, H01B3/00, H05K1/03

Documentation searched other than minimum documentation to the extent that such documents are included in the fields searched

| | | | |
| --- | --- | --- | --- |
| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 6-64924 A (Tayca Corporation),<br>08 March, 1994 (08.03.1994) (Family: none) | 1-8 |
| Y | JP 7-240117 A (Matsushita Electric Works, Ltd.),<br>12 September, 1995 (12.09.1995) (Family: none) | 1-8 |
| Y | JP 7-162111 A (Murata Mfg. Co., Ltd.),<br>23 June, 1995 (23.06.1995) (Family: none) | 1-8 |
| Y | JP 3-147205 A (Murata Mfg. Co., Ltd.),<br>24 June, 1991 (24.06.1991) (Family: none) | 3 |

☐ Further documents are listed in the continuation of Box C.    ☐ See patent family annex.

| | |
| --- | --- |
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>   08 February, 2002 (08.02.02) | Date of mailing of the international search report<br>   19 February, 2002 (19.02.02) |
| Name and mailing address of the ISA/<br>   Japanese Patent Office | Authorized officer |
| Facsimile No. | Telephone No. |

Form PCT/ISA/210 (second sheet) (July 1992)